(19) Europäisches Patentamt
European Patent Office
Office européen des brevets

(11) EP 4 679 984 A1

(12) **EUROPEAN PATENT APPLICATION**
published in accordance with Art. 153(4) EPC

(43) Date of publication:
**14.01.2026 Bulletin 2026/03**

(21) Application number: **24767160.5**

(22) Date of filing: **05.03.2024**

(51) International Patent Classification (IPC):
***H10K 30/50*** *(2023.01)* ***C07F 9/6561*** *(2006.01)*
***H10K 30/40*** *(2023.01)* ***H10K 30/86*** *(2023.01)*
***H10K 85/50*** *(2023.01)*

(52) Cooperative Patent Classification (CPC):
**C07F 9/6561; H10K 30/40; H10K 30/50;**
**H10K 30/86; H10K 85/50;** Y02E 10/549

(86) International application number:
**PCT/JP2024/008379**

(87) International publication number:
**WO 2024/185793 (12.09.2024 Gazette 2024/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.03.2023 JP 2023034065**

(71) Applicant: **Enecoat Technologies Co., Ltd.**
**Kyoto 613-0031 (JP)**

(72) Inventors:
- **WAKAMIYA, Atsushi**
**Kyoto-shi, Kyoto 606-8501 (JP)**
- **TRUONG, Minh Anh**
**Kyoto-shi, Kyoto 606-8501 (JP)**
- **KANEKO, Ryuji**
**Kuse-gun, Kyoto 613-0031 (JP)**
- **YAMAMOTO, Shuhei**
**Kuse-gun, Kyoto 613-0031 (JP)**

(74) Representative: **Becker, Eberhard**
**Becker Kurig & Partner**
**Patentanwälte mbB**
**Bavariastraße 7**
**80336 München (DE)**

(54) **PHOTOELECTRIC CONVERSION ELEMENT**

(57) Provided is a photoelectric conversion element that can form a high-quality perovskite layer without using a poor solvent method, and that has excellent properties. The photoelectric conversion element is characterized by comprising a first electrode, an electron transport layer, a photoelectric conversion layer, a hole transport layer, and a second electrode, which are layered in this order, and characterized in that: the hole transport layer includes a compound represented by chemical formula (I); and the photoelectric conversion layer includes a perovskite compound that is formed of a material containing at least one of formamidine and a salt thereof. In chemical formula (I), $Ar^1$ is a structure containing an aromatic ring; atoms that constitute the aromatic ring optionally include a heteroatom; $Ar^1$ optionally includes a substituent other than $-L^1-X^1$; $-L^1-X^1$ may be single or multiple, and if multiple, the plurality of $L^1$ may be mutually the same or different and the plurality of $X^1$ may be mutually the same or different; each $L^1$ may be an atom that binds $Ar^1$ and $X^1$ together, or a covalent bond; and each $X^1$ may be a group capable of exchanging electrical charges with the first electrode.

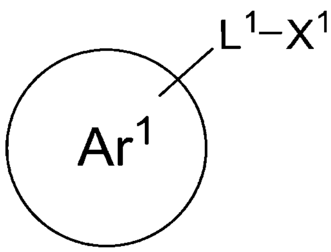

( I )

EP 4 679 984 A1

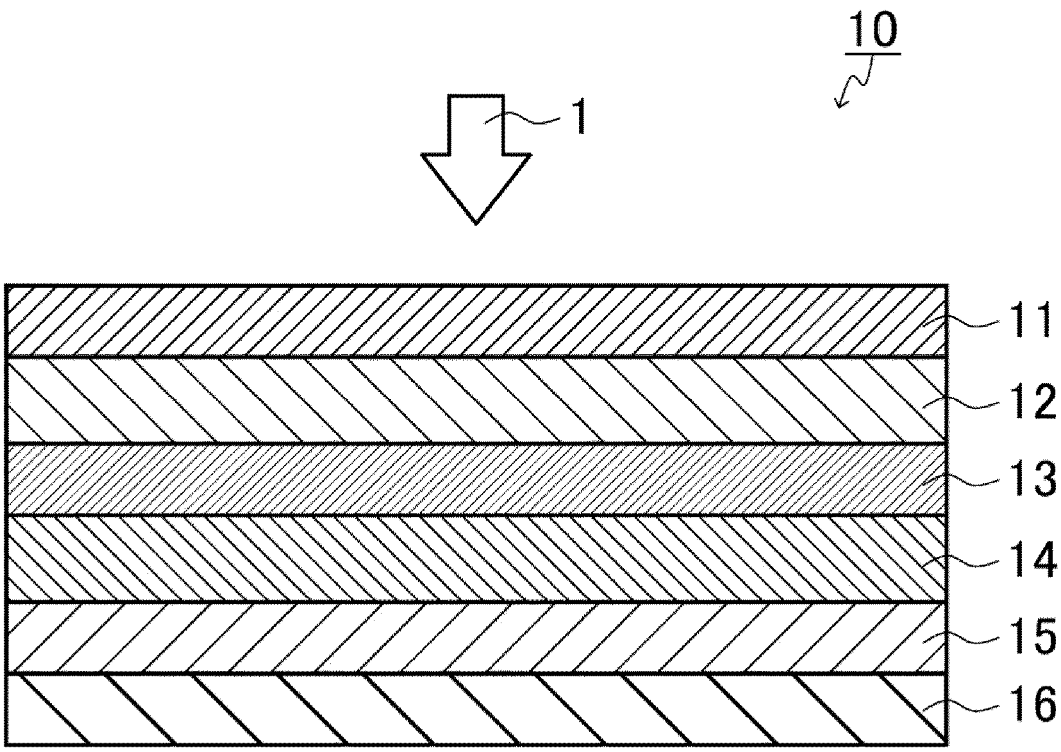


FIG. 1

## Description

Technical Field

The disclosure relates to a photoelectric conversion element.

Background Art

In recent years, solar power generation has attracted attention as clean energy, and development of solar cells has been progressing. As one type of solar cells, solar cells using a perovskite material in the light absorption layer have rapidly attracted attention as next-generation solar cells that can be manufactured at low cost. For example, Non-Patent Document 1 reports a solution-type solar cell using a perovskite material in the light absorption layer. Non-Patent Document 2 also reports that a solid-type perovskite type solar cell shows high efficiency.

In addition, a method of dropping a poor solvent before drying is known as a technique to promote crystallization in forming a perovskite layer. This poor solvent method obtains high-quality crystals and therefore demonstrates efficacy when used for obtaining high conversion efficiency with small cells, but has the drawback of being difficult to be applied to coating methods other than spin coating.

Related Art Documents

Non-Patent Documents

Non-Patent Document 1: Journal of the American Chemical Society, 2009, 131, 6050-6051.
Non-Patent Document 2: Science, 2012, 388, 643-647.

SUMMARY OF INVENTION

Problem to be Solved by the Invention

Although the poor solvent method has the aforementioned drawback, it is difficult to obtain a high-quality perovskite layer comparable to the poor solvent method using methods other than the poor solvent method.

Thus, the disclosure aims to provide a photoelectric conversion element that can form a high-quality perovskite layer without using a poor solvent method, and that has excellent characteristics.

Means for Solving the Problem

To achieve the above objective, a photoelectric conversion element of the disclosure is characterized in including:

a first electrode, an electron transport layer, a photoelectric conversion layer, a hole transport layer, and a second electrode laminated in the order,
the hole transport layer includes a compound represented by the following chemical formula (I), and
the photoelectric conversion layer includes a perovskite compound, and the perovskite compound is a perovskite compound formed from a raw material including at least one of formamidine and a salt thereof.

[Chemical Formula I]

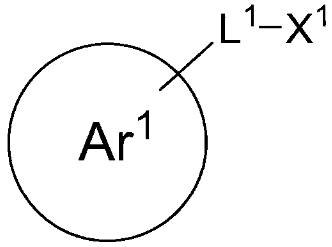

( I )

In the chemical formula (I),

$Ar^1$ is a structure including an aromatic ring, and optionally includes a heteroatom among atoms constituting the aromatic ring,
$Ar^1$ optionally has a substituent other than $-L^1-X^1$,
$-L^1-X^1$ is single or multiple, and in the case of being multiple, each $L^1$ is the same as or different from each other and each $X^1$ is the same as or different from each other,
each $L^1$ is an atomic group that bonds $Ar^1$ and $X^1$, or is a covalent bond, and
each $X^1$ is a group capable of exchanging charges with the first electrode.

Effects of the Invention

According to the disclosure, it is possible to provide a photoelectric conversion element that can form a high-quality perovskite layer without using a poor solvent method, and that has excellent characteristics.

BRIEF DESCRIPTION OF THE DRAWINGS

[FIG. 1] FIG. 1 is a cross-sectional view showing an example of the configuration in the photoelectric conversion element of the disclosure.

[FIG. 2] FIG. 2 is a $^1H$ NMR chart of compound 3PATAT produced in the examples.

[FIG. 3] FIG. 3 is a $^{13}C$ NMR chart of compound 3PATAT produced in the examples.

[FIG. 4] FIG. 4 is a $^{31}P$ NMR chart of compound 3PATAT produced in the examples.

DESCRIPTION OF THE EMBODIMENTS

Next, the disclosure will be described in further detail with examples. Nevertheless, the disclosure is not limited by the following description.
In the disclosure, unless otherwise specified, "mass%" and "weight%" may be read interchangeably with each other, and "parts by mass" and "parts by weight" may be read interchangeably with each other.
In the disclosure, "on" or "on the surface" may refer to a state of direct contact on or on the surface, or may refer to a state with other components or the like therebetween.

[Photoelectric Conversion Element]

As described above, the photoelectric conversion element of the disclosure includes a first electrode, an electron transport layer, a photoelectric conversion layer, a hole transport layer, and a second electrode laminated in the order, in which the hole transport layer includes a compound represented by the chemical formula (I), the photoelectric conversion layer includes a perovskite compound, and the perovskite compound is a perovskite compound formed from a raw material

including at least one of formamidine and a salt thereof.

The photoelectric conversion element of the disclosure may or may not include components other than the first electrode, the electron transport layer, the photoelectric conversion layer, the hole transport layer, and the second electrode. For example, the photoelectric conversion element of the disclosure may include a support body as described later. In addition, adjacent components among the first electrode, the electron transport layer, the photoelectric conversion layer, the hole transport layer, and the second electrode may be laminated in a state of direct contact without other components or the like therebetween, or may be laminated with other components or the like therebetween.

Hereinafter, the configuration and each component of the photoelectric conversion element of the disclosure will be described more specifically with examples. Nevertheless, the photoelectric conversion element of the disclosure is not limited to the following examples. The following mainly describes a case where the photoelectric conversion element of the disclosure is a solar cell.

FIG. 1 shows an example of the configuration of the photoelectric conversion element of the disclosure. FIG. 1 is schematically drawn with appropriate omission, exaggeration, etc. for convenience of illustration. As shown in the drawing, the photoelectric conversion element of the disclosure is a perovskite solar cell, and shows an inverted structure.

[Support Body 11]

The support body 11 is not particularly limited, and for example, a substrate usable for photoelectric conversion elements such as general solar cells may be appropriately used. Examples of the substrate include glass, a plastic plate, a plastic film, inorganic crystal, etc. A substrate having at least one type of film, among a metal film, a semiconductor film, a conductive film, and an insulating film, formed on part or all of the surface of these substrates can also be suitably used as the support body 11. The size, thickness, etc. of the support body 11 are not particularly limited, either, and may be, for example, the same as or similar to the size, thickness, etc. of photoelectric conversion elements such as general solar cells.

[First Electrode 12]

The first electrode 12 is, for example, a layer that has a function of supporting the hole transport layer 13 and extracting holes from the photoelectric conversion layer 14. In addition, the first electrode 12 is, for example, a layer that works as a cathode (positive electrode).

The first electrode 12 may be formed directly on the support body 11, for example. The first electrode 12 may be, for example, a transparent electrode formed of a conductor. The transparent electrode is not particularly limited, but examples include a tin-doped indium oxide (ITO) film, an impurity-doped indium oxide ($In_2O_3$) film, an impurity-doped zinc oxide (ZnO) film, a fluorine-doped tin dioxide (FTO) film, a laminated film formed by laminating two or more types of these, gold, silver, copper, aluminum, tungsten, titanium, chromium, nickel, cobalt, etc. These may be used alone or in a mixture of two or more types, and may be a single layer or a laminated layer. In addition, these films may function as, for example, diffusion barrier layers. The thickness of the first electrode 12 is not particularly limited, but the thickness is preferably adjusted so that the sheet resistance becomes 5 Ω/□ to 15 Ω/□ (per unit area), for example. The formation method of the first electrode 12 is not particularly limited, but the first electrode 12 can be obtained by a known film formation method according to the material to be formed, for example. Further, the shape of the first electrode 12 is not particularly limited, but may be, for example, film-like or formed in a lattice shape like a mesh. The method of forming the first electrode 12 on the support body 11 is not particularly limited, but may be a known method, for example, and vacuum film formation such as vacuum deposition or sputtering is preferable. Also, the first electrode 12 may be patterned. The patterning method is not particularly limited, but examples include methods using laser or immersion in etching solutions, methods of patterning using masks during vacuum film formation, etc., and any of these methods may be used in the disclosure. In addition, the first electrode 12 may be used in combination with metal wiring or the like for the purpose of reducing electrical resistance. The material of the metal wiring (metal lead wire) is not particularly limited, but examples include aluminum, copper, silver, gold, platinum, nickel, etc. The metal lead wire can be used in combination by, for example, forming the metal lead wire on a first substrate by deposition, sputtering, pressure bonding, or the like, and providing an ITO or FTO layer thereon, or by providing the metal lead wire on ITO or FTO.

[Hole Transport Layer 13]

The hole transport layer 13 includes the compound represented by the chemical formula (I) as described above. The compound represented by the chemical formula (I) has group $X^1$ capable of exchanging charges with the first electrode, and therefore can function as a hole transport compound. The compound represented by the chemical formula (I) can function, for example, as a hole transport compound that forms a monomolecular layer (hereinafter also referred to as "monomolecular hole transport compound"). The monomolecular hole transport compound desirably has an anchor

that chemically bonds with the first electrode (for example, ITO which is a transparent electrode) in an inverted structure, for example. Examples of the anchor include a phosphonic acid group, a carboxyl group, a sulfo group, a boronic acid group, a trihalogenated silyl group, a trialkoxysilyl group, a trihydroxysilyl group, etc. Among these, a phosphonic acid group, a trihalogenated silyl group, and a trialkoxysilyl group are particularly preferable. For example, group $X^1$ capable of exchanging charges with the first electrode in the chemical formula (I) is preferably a group capable of forming a chemical bond or a hydrogen bond with the first electrode (that is, anchor). In the disclosure, "chemical bond" refers to a bond between atoms or ions forming molecules, crystals, etc., and may be, for example, a covalent bond, an ionic bond, or a metallic bond, or a bond with multiple of these bonding modes mixed.

In the chemical formula (I), the number of $-L^1-X^1$ is not particularly limited, but may be, for example, in the range of 1 to 4.

In the photoelectric conversion element of the disclosure, for example, in the chemical formula (I), each $X^1$ may respectively be a phosphonic acid group ($-P{=}O(OH)_2$), a carboxy group ($-COOH$), a sulfo group ($-SO_3H$), a boronic acid group ($-B(OH)_2$), a trihalogenated silyl group ($-SiX_3$, where X is a halo group), or a trialkoxysilyl group ($-Si(OR)_3$, where R is an alkyl group).

In the photoelectric conversion element of the disclosure, for example, in the chemical formula (I), the $Ar^1$ may be represented by the following chemical formula (I-1).

[Chemical Formula I-1]

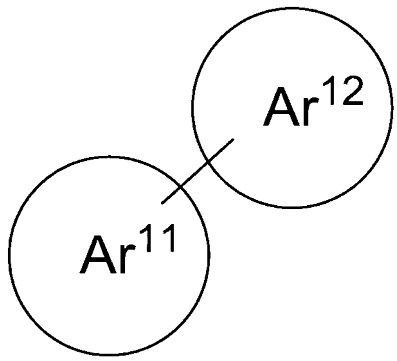

(I − 1)

In the chemical formula (I-1),

$Ar^{11}$ is an atomic group including a cyclic structure, and the cyclic structure may be an aromatic ring or a non-aromatic ring, may be a monocyclic ring, a condensed ring, or a spiro ring, and may or may not include a heteroatom among the atoms constituting the ring,
$Ar^{12}$ is an aromatic ring, and may or may not include a heteroatom among the atoms constituting the ring,
$Ar^{12}$ may share one or more atoms with $Ar^{11}$ and be integrated with $Ar^{11}$, and
$Ar^{12}$ may be single or multiple, and in the case of being multiple, $Ar^{12}$ may be the same as or different from each other. The number of $Ar^{12}$ is not particularly limited, but may be, for example, in the range of 1 to 4.

In the photoelectric conversion element of the disclosure, for example, in the chemical formula (I-1), the $Ar^{11}$ may be represented by any of the following chemical formulas (a1) to (a10).

[Chemical Formulas a1 to a10]

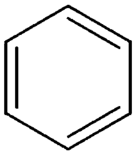

(a 1)

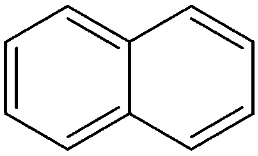

(a 2)

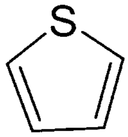

(a 3)

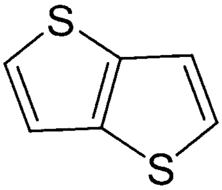

(a 4)

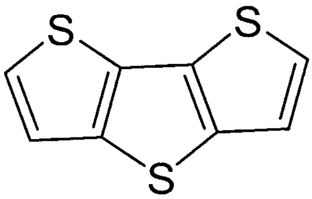

(a 5)

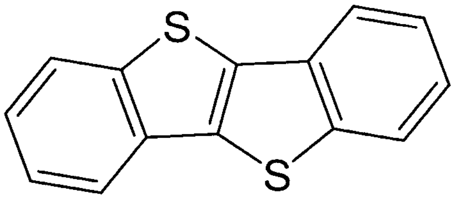

(a 6)

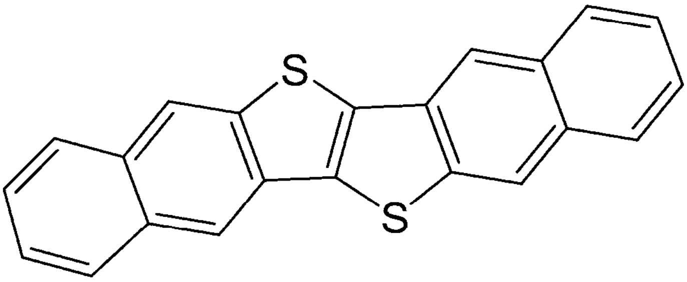

(a 7)

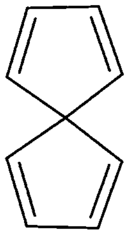

(a 8)

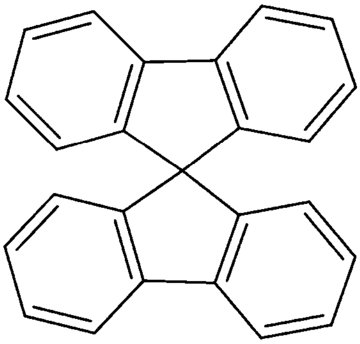

(a 9)

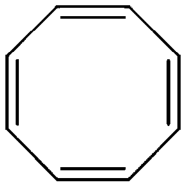

(a 10)

In the photoelectric conversion element of the disclosure, for example, in the chemical formula (I-1), each of the $Ar^{12}$ may be respectively represented by the following chemical formula (b).

[Chemical Formula b]

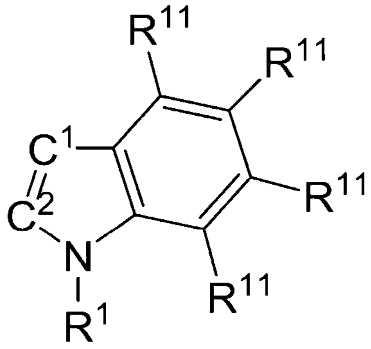

(b)

In the chemical formula (b),

carbon atoms $C^1$ and $C^2$ also serve as part of the atoms constituting the cyclic structure in the $Ar^{11}$ in the chemical formula (I-1),
the $R^1$ is a hydrogen atom, $X^1$ in the chemical formula (I), or a substituent, the substituent may or may not include a hydrogen atom, and at least one of the hydrogen atoms in the substituent may be substituted with $X^1$ in the chemical formula (I),
each of the $R^{11}$ may be the same as or different from each other, and each is a hydrogen atom or a substituent, or two adjacent $R^{11}$ may form a condensed ring together with the benzene ring to which the $R^{11}$ are bonded, and
each of the $R^{11}$ may or may not further have a substituent.

In the photoelectric conversion element of the disclosure, for example, the chemical formula (b) may be represented by any one of the following chemical formulas (b1) to (b7).

[Chemical Formulas b1 to b7]

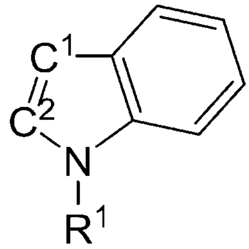

(b 1)

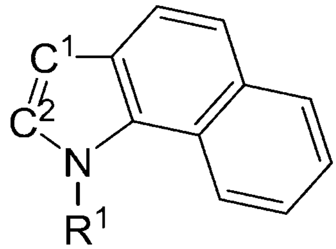

(b 2)

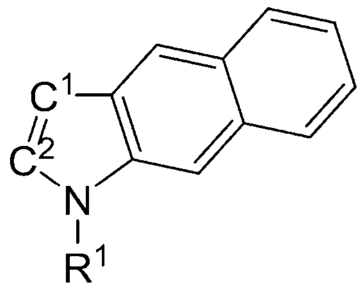

(b 3)

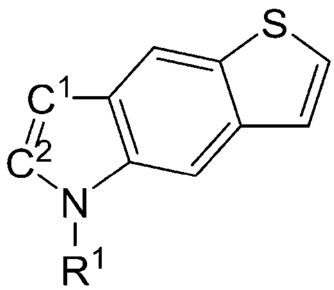

(b 4)

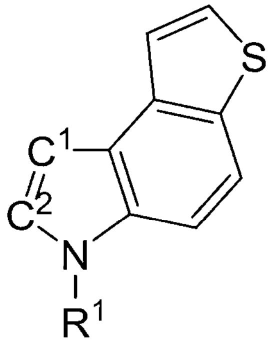

(b 5)

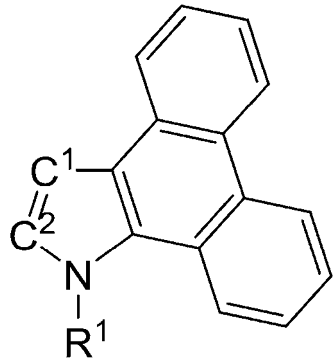

(b 6)

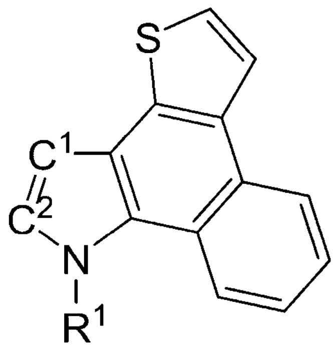

(b 7)

In the chemical formulas (b1) to (b7), $C^1$, $C^2$, and $R^1$ are respectively the same as those in the chemical formula (b).

In the photoelectric conversion element of the disclosure, specific examples of the compound represented by the chemical formula (I) include compounds represented by any one of the following chemical formulas A-1 to A-23.

[Chemical Formulas A1A4]

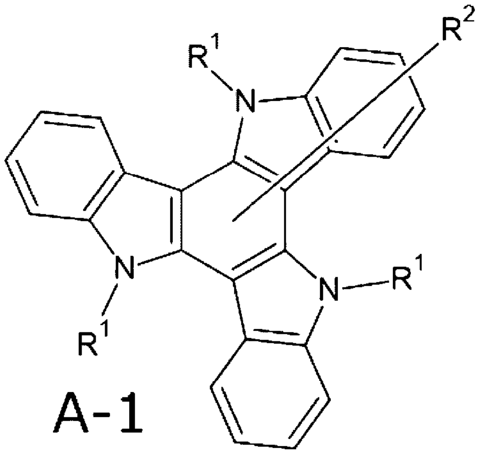

A-1

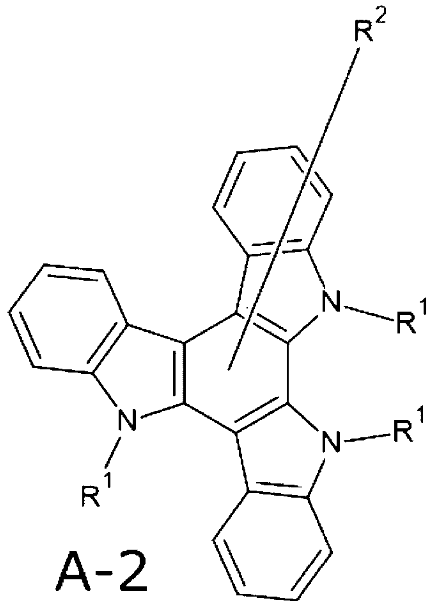

A-2

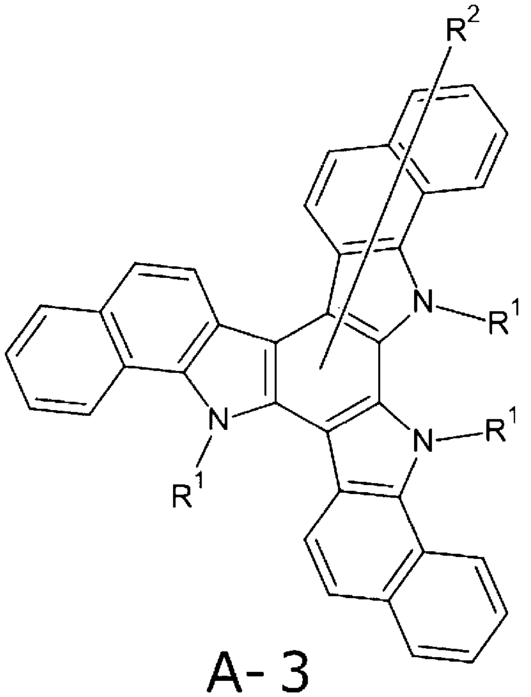

A-3

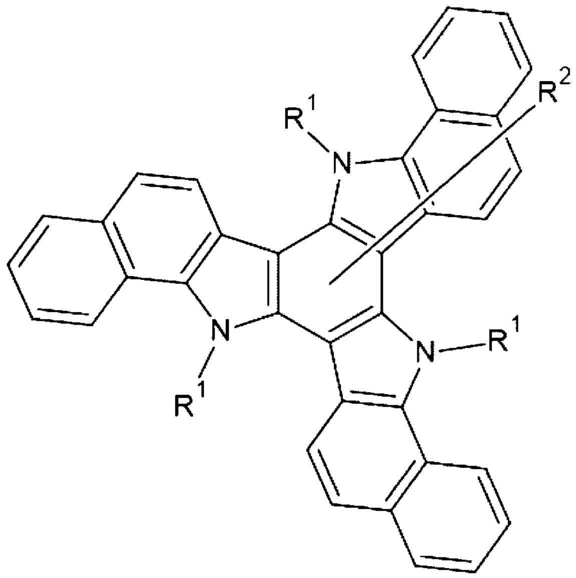

A-4

[Chemical Formulas A5A8]

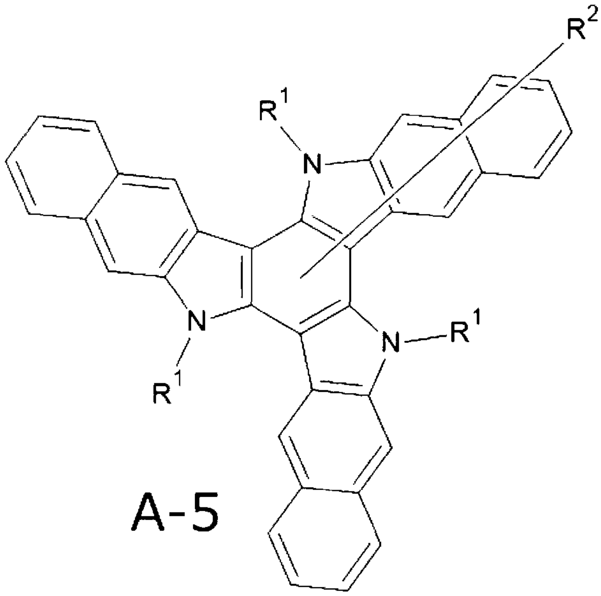

A-5

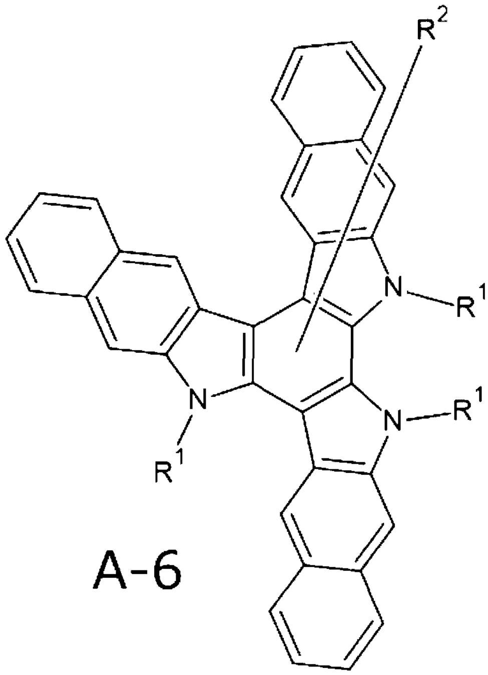

A-6

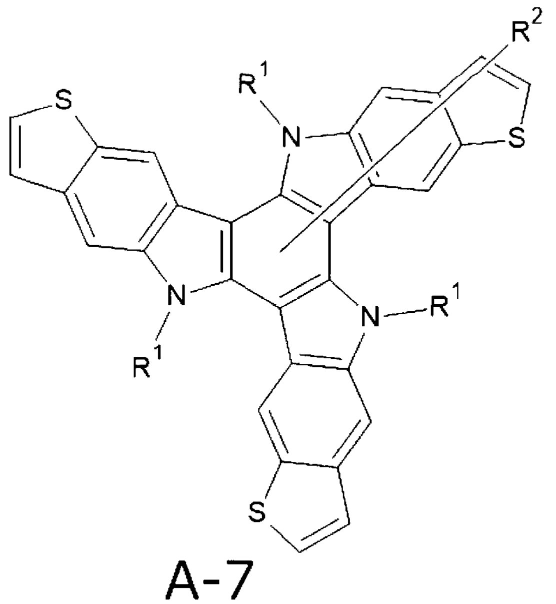

A-7

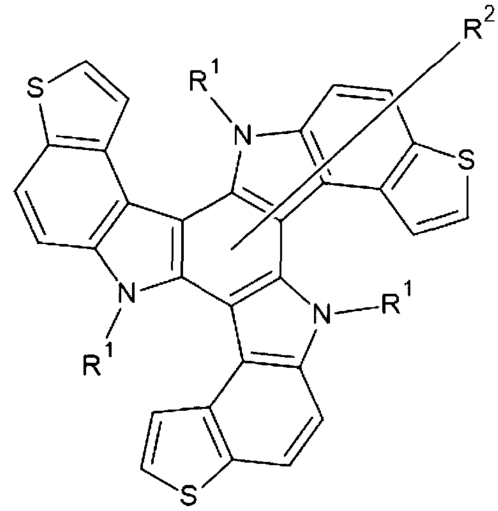

A-8

[Chemical Formulas A9A12]

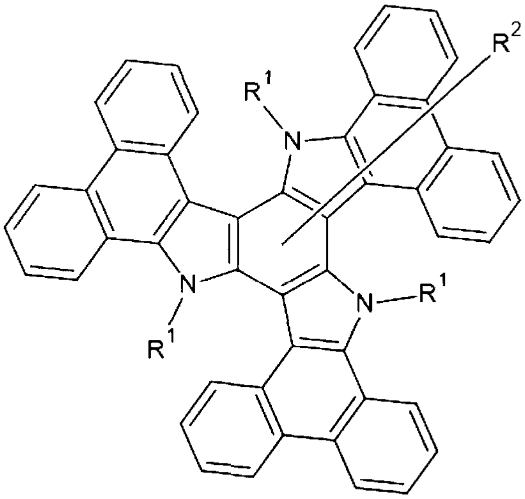

A-9

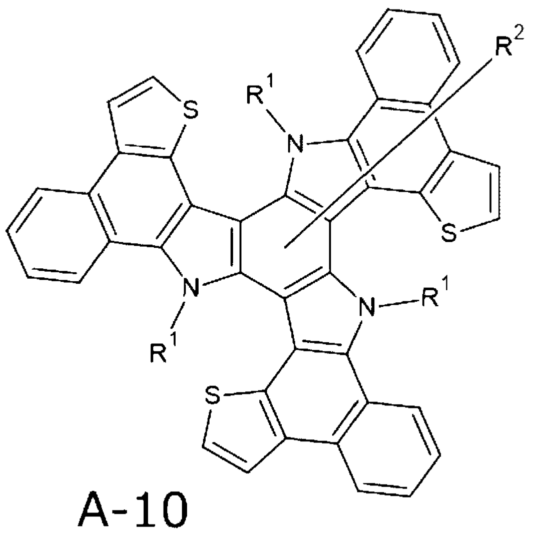

A-10

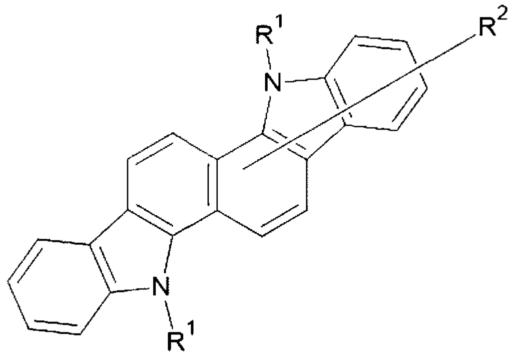

A-11

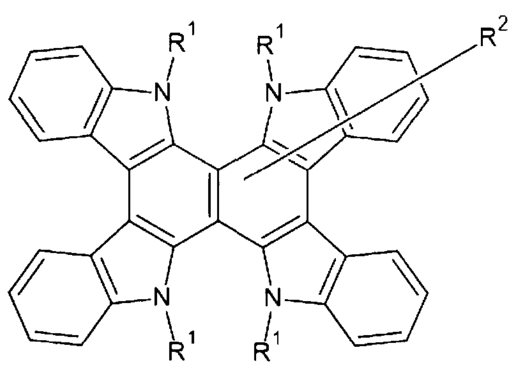

A-12

[Chemical Formulas A13A16]

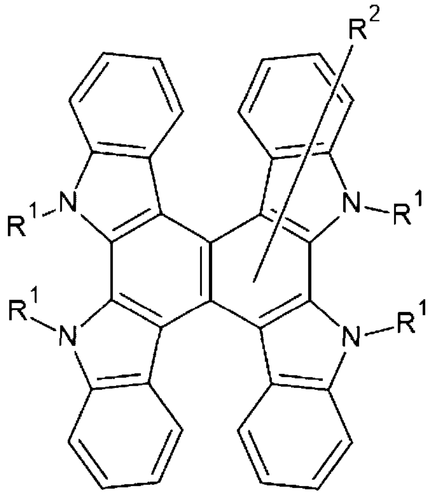

A-13

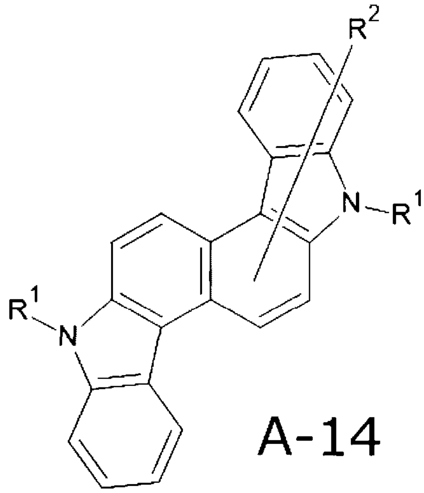

A-14

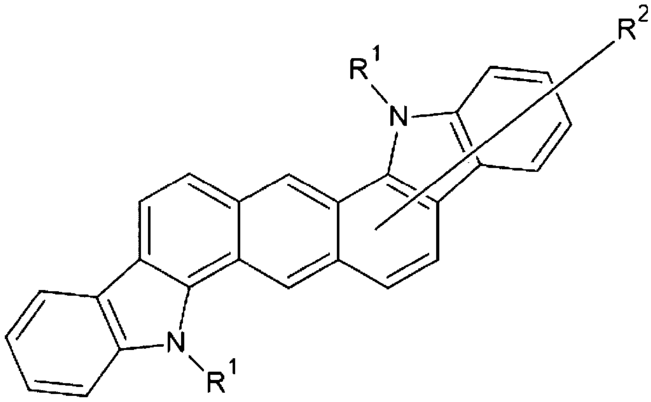

A-15

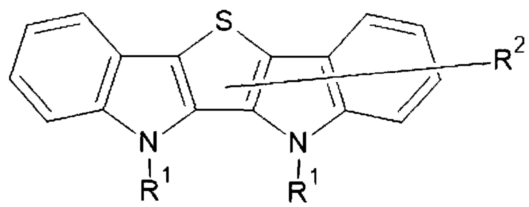

A-16

[Chemical Formulas A17A20]

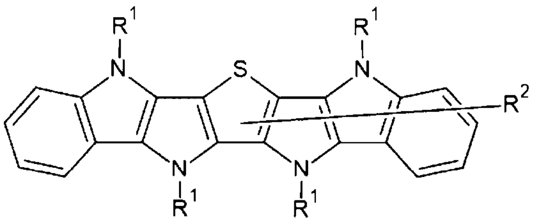

A-17

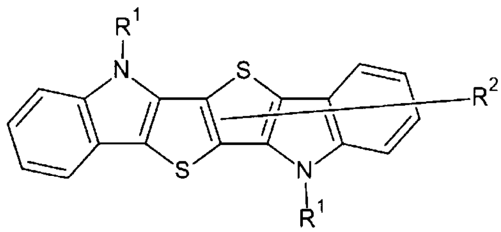

A-18

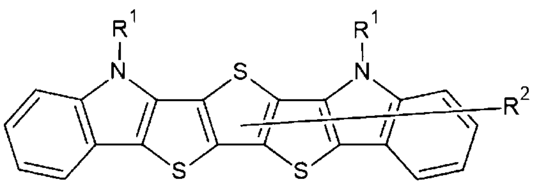

A-19

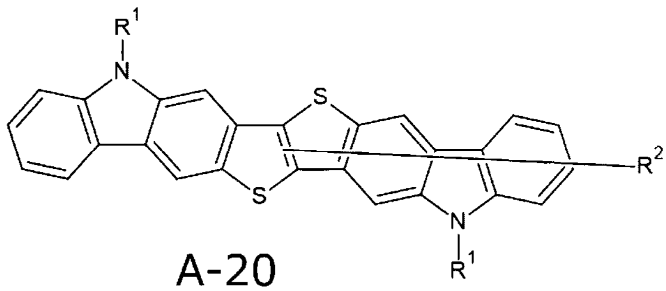

A-20

[Chemical Formulas A21A23]

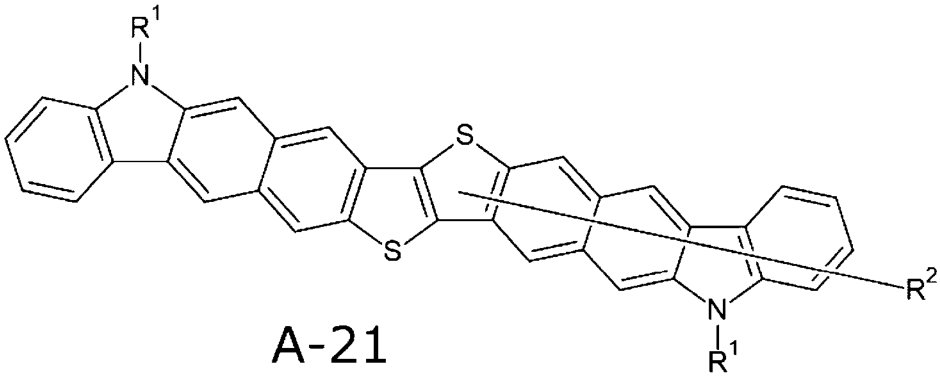

A-21

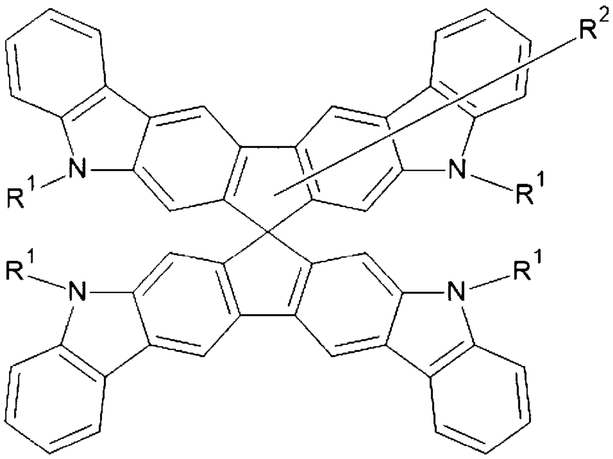

A-22

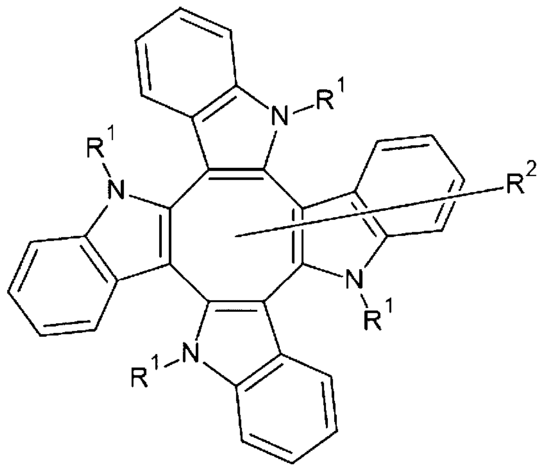

A-23

In the chemical formulas A-1 to A-23, each of the $R^1$ is a hydrogen atom, $X^1$ in the chemical formula (I), or a substituent further substituted with $X^1$ in the chemical formula (I), and may be the same as or different from each other, at least one of the $R^1$ is $X^1$ in the chemical formula (I) or a substituent further substituted with $X^1$ in the chemical formula (I), and the $R^2$ is a substituent, and may exist as one, multiple, or may not exist, and in the case of being multiple, each $R^2$ may be the same as or different from each other.

In the chemical formulas A-1 to A-23, in the case of $R^1$ being a substituent further substituted with $X^1$ in the chemical formula (I), the number of $X^1$ may be one or more. Additionally, in the case of $R^1$ being a substituent further substituted with $X^1$ in the chemical formula (I), for example, $R^1$ may be an alkyl group or an alkoxy group further substituted with $X^1$ in the chemical formula (I).

In the chemical formulas A-1 to A-23, the number of the substituents $R^2$ is not particularly limited. In addition, the substituent $R^2$ may each be, for example, an alkyl group, an alkoxy group, or a halo group (halogen atom).

In the photoelectric conversion element of the disclosure, for example, the compound represented by the chemical formula (I) may be a compound represented by the following chemical formula 4PATAT, 1-legged-3PATAT, 1-legged-3PATAT-H, 2-legged-3PATAT, 4PATTI-C3, 4PATTI-C4, or 3PATAT.

[Chemical Formula 4PATAT]

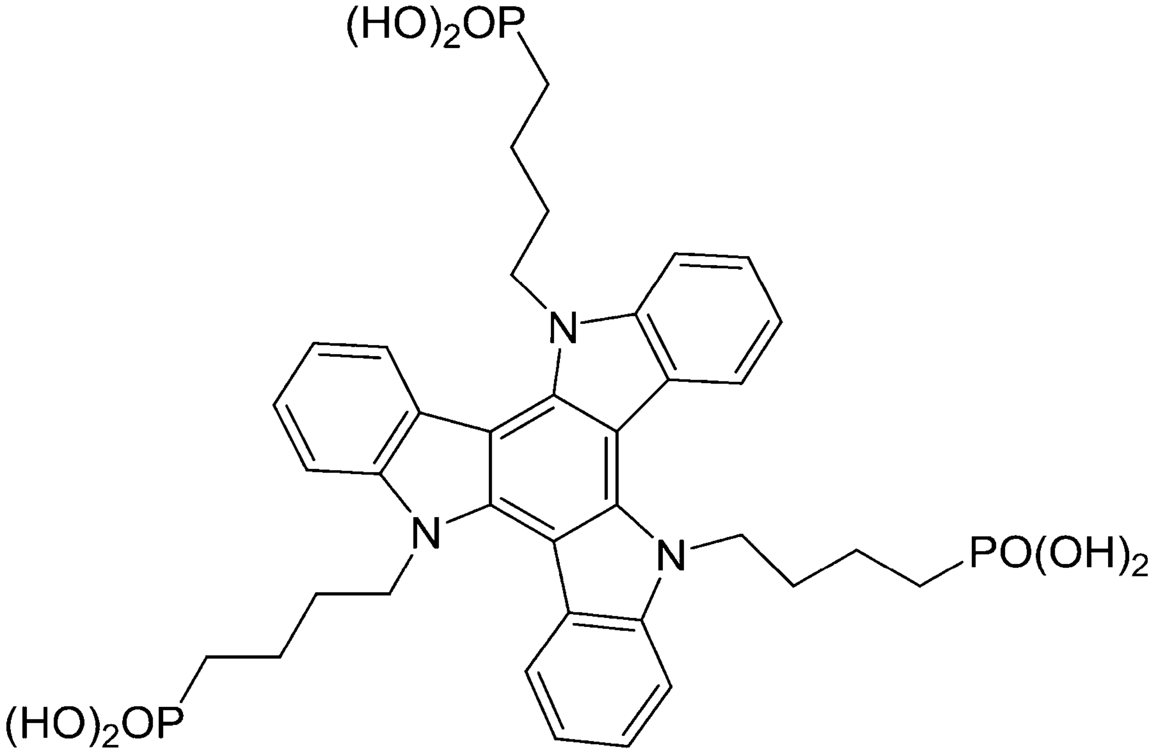

4PATAT

[Chemical Formula 3PATAT1]

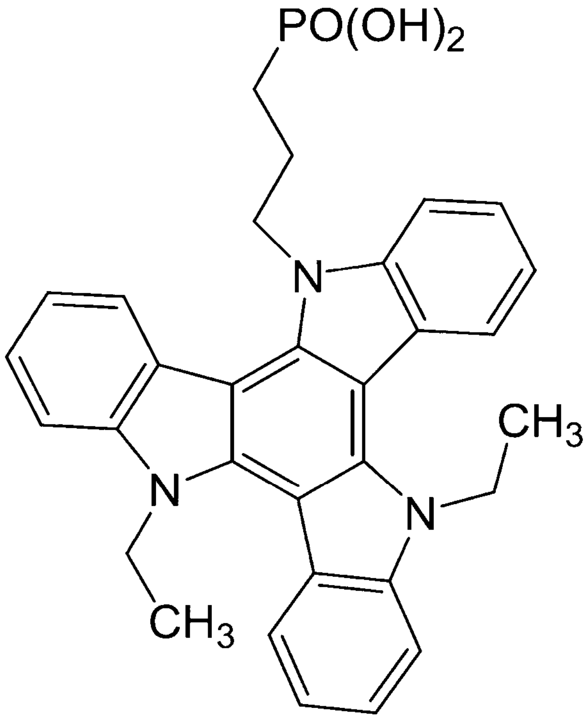

1－ｌｅｇｇｅｄ－3PATAT

[Chemical Formula 3PATATH]

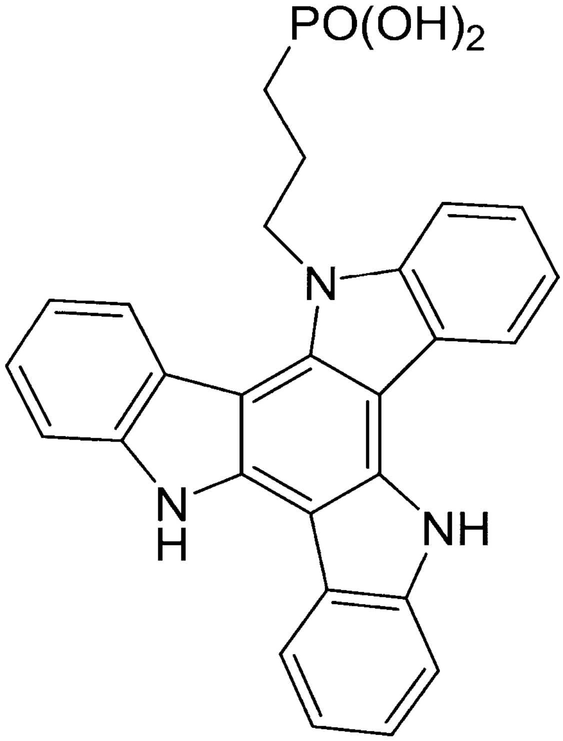

1－legged－3PATAT－H

[Chemical Formula 3PATAT2]

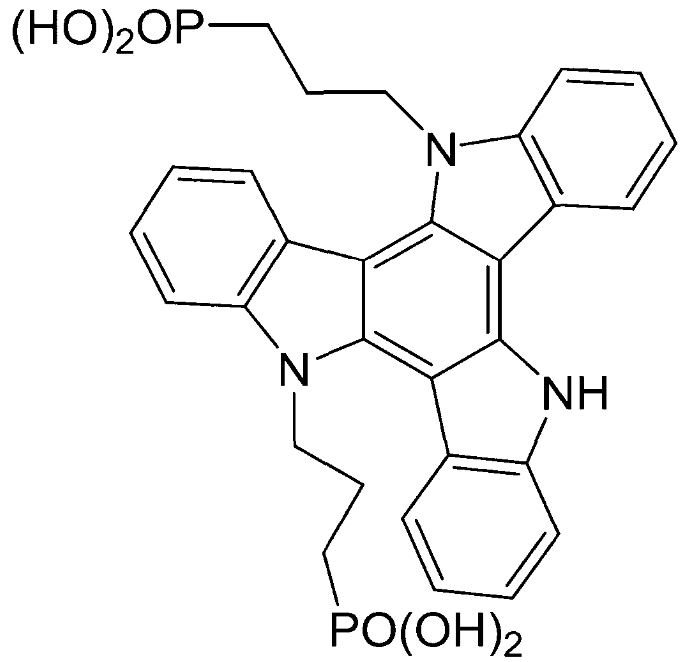

2-legged-3PATAT

[Chemical Formula 4PATTI-C3]

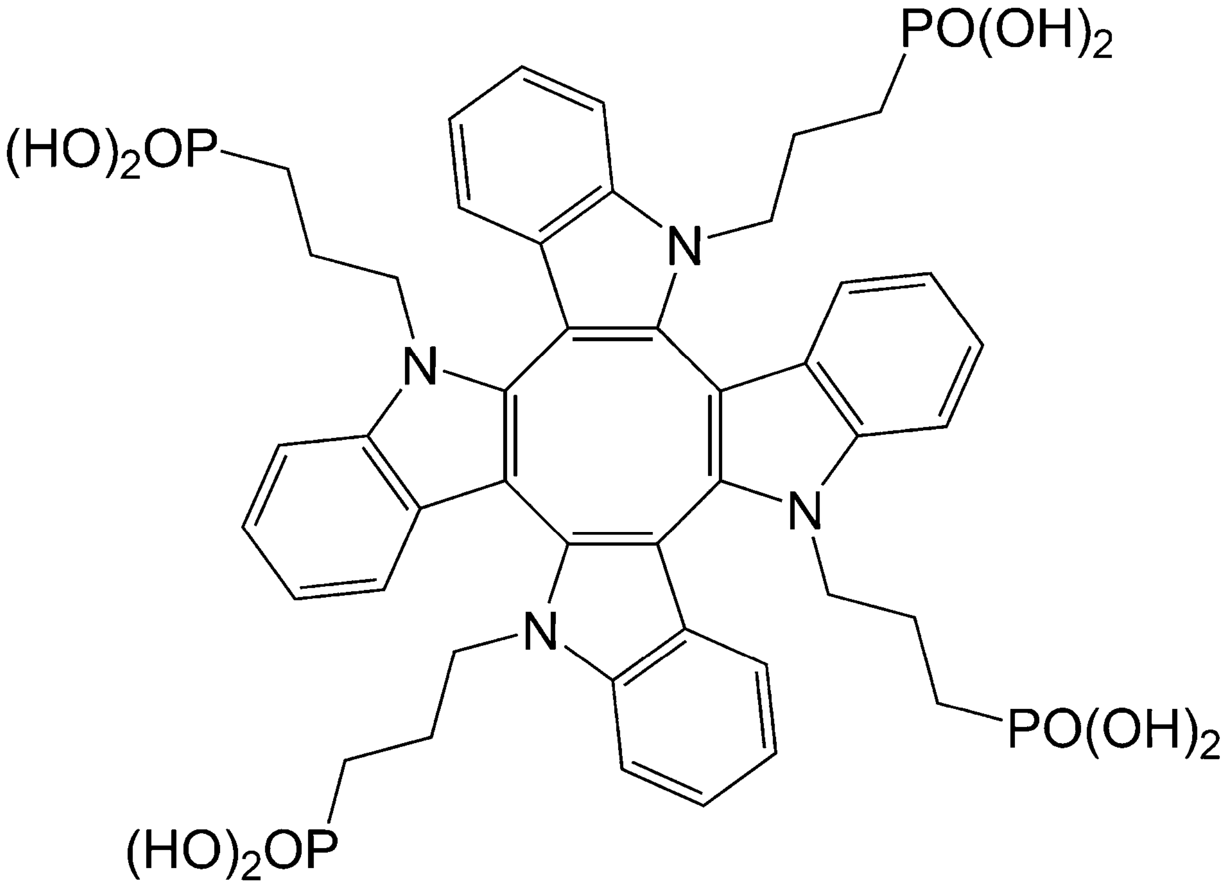

4PATTI-C3

[Chemical Formula 4PATTI-C4]

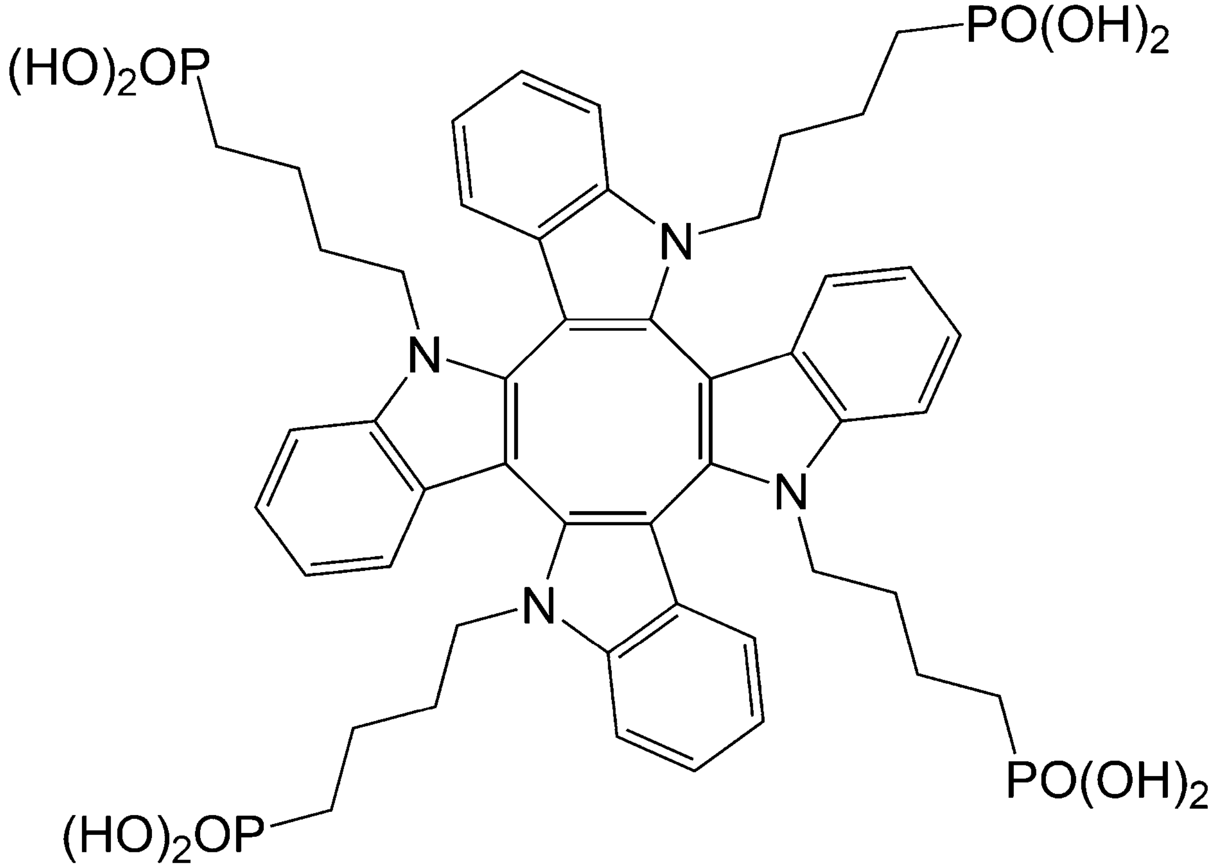

4PATTI-C4

[Chemical Formula 3PATAT]

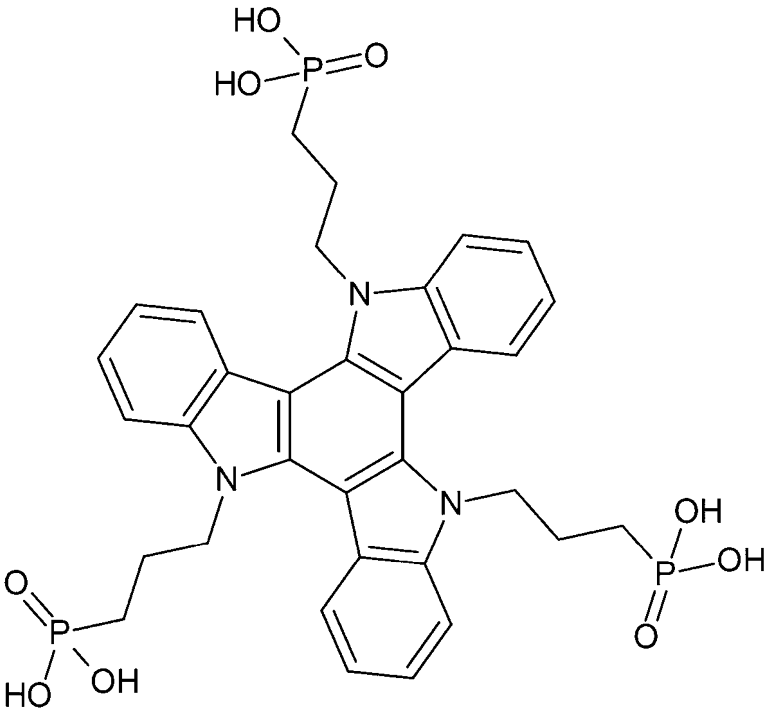

3PATAT

In the disclosure, chain-like groups or atomic groups (for example, hydrocarbon groups such as alkyl groups and unsaturated aliphatic hydrocarbon groups) may be linear or branched unless otherwise specified, and the number of carbon atoms is not particularly limited, but may be, for example, 1 to 40, 1 to 32, 1 to 24, 1 to 18, 1 to 12, 1 to 6, or 1 to 2 (2 or more in the case of unsaturated hydrocarbon groups). Further, in the disclosure, the number of ring members (the number of atoms constituting the ring) of cyclic groups or atomic groups (for example, aromatic rings, aromatic groups, etc., such as aryl groups and heteroaryl groups) is not particularly limited, but may be, for example, 5 to 32, 5 to 24, 6 to 18, 6 to 12, or 6 to 10. Further, in the case of isomers existing in the substituent, etc., any isomer may be used unless otherwise specified. For example, in the case of simply referring to a "naphthyl group," the naphthyl group may be a 1-naphthyl group or a 2-naphthyl group.

In the disclosure, "substituent" is not particularly limited, but examples include an alkyl group, an unsaturated aliphatic hydrocarbon group, an alkoxy group, an aralkyl group, an aryl group, a heteroaryl group, a halogen, an amino group (-$NR^1R^2$, $R^1$, and $R^2$ are hydrogen atoms, alkyl groups, and aryl groups), a hydroxy group (-OH), a mercapto group (-SH), an alkylthio group (-$SR^2$ and $R^2$ are alkyl groups), a sulfo group, a nitro group, a diazo group, a cyano group, a trifluoromethyl group, etc.

Furthermore, in the disclosure, in the case of isomers such as tautomers or stereoisomers (for example, geometric isomers, conformational isomers, and optical isomers) existing in the compound, any isomer can be used in the disclosure unless otherwise specified. Additionally, in the disclosure, in the case of a compound capable of forming a salt, the salt can also be used in the disclosure unless otherwise specified. The salt may be an acid addition salt or a base addition salt. Furthermore, the acid forming the acid addition salt may be an inorganic acid or an organic acid, and the base forming the base addition salt may be an inorganic base or an organic base. The inorganic acid is not particularly limited, but examples include sulfuric acid, phosphoric acid, hydrofluoric acid, hydrochloric acid, hydrobromic acid, hydroiodic acid, hypofluorous acid, hypochlorous acid, hypobromous acid, hypoiodous acid, fluorous acid, chlorous acid, bromous acid, iodous acid, fluoric acid, chloric acid, bromic acid, iodic acid, perfluoric acid, perchloric acid, perbromic acid, periodic acid, etc. The organic acid is not particularly limited, either, but examples include p-toluenesulfonic acid, methanesulfonic acid, oxalic acid, p-bromobenzenesulfonic acid, carbonic acid, succinic acid, citric acid, benzoic acid, acetic acid, etc. The inorganic base is not particularly limited, but examples include ammonium hydroxide, alkali metal hydroxide, alkaline earth metal hydroxide, carbonate, hydrogen carbonate, etc., and more specifically, examples include sodium hydroxide, potassium hydroxide, potassium carbonate, sodium carbonate, sodium hydrogen carbonate, potassium hydrogen carbonate, calcium hydroxide, calcium carbonate, etc. The organic base is not particularly limited, either, but examples include ethanolamine, triethylamine, tris(hydroxymethyl)aminomethane, etc. The production method of these salts is not particularly limited, either, and for example, the salts can be produced by a method of appropriately adding the

aforementioned acids or bases to the compound by known methods. The production method of these salts may be, for example, a method of manufacturing a device using a compound that has already formed a salt, or a method of manufacturing a device using a compound before forming a salt and then forming the salt.

In the disclosure, the compound represented by the chemical formula (I) may form a salt as described above, and the salt is preferably an acid addition salt. The acid forming the acid addition salt may be an inorganic acid or an organic acid. The inorganic acid and the organic acid are not particularly limited, but specific examples thereof are as described above. The production method of the acid addition salt is not particularly limited, either, but is, for example, as described above.

In addition, the synthesis (production) method of the compound represented by the chemical formula (I) is not particularly limited, and for example, the compound can be synthesized in the same manner as, or according to, or with reference to synthesis methods of compounds having similar structures.

The formation method of the hole transport layer 13 is not particularly limited, and for example, the hole transport layer 13 can be performed by an appropriate method in the same manner as, or according to, or with reference to general photoelectric conversion elements. Although the following mainly describes a case where the compound represented by the chemical formula (I) is a monomolecular hole transport compound, the hole transport layer 13 can be formed by the same method in a case where the compound is not a monomolecular hole transport compound.

The formation method of the hole transport layer 13 using the monomolecular hole transport compound is not particularly limited, but for example, the hole transport layer 13 can be formed by adsorbing the monomolecular hole transport compound to the first electrode 12 to form a monomolecular layer. The method of adsorbing the monomolecular hole transport compound to the first electrode 12 to form a monomolecular layer is not particularly limited, but for example, the monomolecular hole transport compound may be dissolved in a solvent and brought into contact with the first electrode 12 to be bonded thereto. The bond between the monomolecular hole transport compound and the first electrode 12 is not particularly limited, and may be a physical bond or a chemical bond. The type of the bond is not particularly limited, either, and may be any of, for example, a hydrogen bond, an ester bond, and a chelate bond. The solvent for dissolving the monomolecular hole transport compound is not particularly limited, either, and may be, for example, one or both of water and an organic solvent. More specifically, examples of the solvent include water, alcohols such as methanol, ethanol, and 2-propanol, ethers such as diethyl ether and diisopropyl ether, ketones such as acetone and methyl isobutyl ketone, esters such as ethyl acetate, isobutyl acetate, and $\gamma$-butyrolactone, heterocycles such as tetrahydrofuran and thiophene, amides such as N,N-dimethylformamide, N,N-dimethylacetamide, and N-methylpyrrolidone, sulfoxides such as dimethyl sulfoxide, sulfones such as diethyl sulfone and sulfolane, nitriles such as acetonitrile and 3-methoxypropionitrile, aromatic compounds such as benzene, toluene, and chlorobenzene, halogenated solvents such as dichloromethane and chloroform, and fluorine-based solvents such as chlorofluorocarbon, hydrochlorofluorocarbon, and hydrofluorocarbon, which may be used alone or in a mixture of two or more types.

The specific method of adsorbing the monomolecular hole transport compound to the first electrode 12 to form a monomolecular layer is not particularly limited, but examples include known methods such as a dipping method, a spray method, a spin coating method, and a bar coating method. The temperature during adsorption is not particularly limited, but is preferably -20°C to 100°C, and more preferably 0°C to 50°C. The adsorption time is not particularly limited, either, but is, for example, preferably 1 second to 48 hours, and more preferably 10 seconds to 1 hour. After the adsorption treatment, for example, washing may or may not be performed. The washing method is not particularly limited, either, but for example, known methods may be appropriately used. Further, after the adsorption treatment or after the washing, heat treatment may or may not be performed. The temperature of the heat treatment is preferably 50°C to 150°C, and more preferably 70°C to 120°C. The heat treatment time is preferably 1 second to 48 hours, and more preferably 10 seconds to 1 hour. In addition, this heat treatment may be performed, for example, in the atmosphere or in a vacuum.

A co-adsorbent may be used in combination in adsorbing the monomolecular hole transport compound to the first electrode 12. The co-adsorbent can be added for the purpose of inhibiting interaction between monomolecular hole transport compounds or in the case where the electrode surface cannot be completely covered by the monomolecular hole transport compound alone. Specific examples of the co-adsorbent include phosphonic acid compounds such as n-butylphosphonic acid, n-hexylphosphonic acid, n-decylphosphonic acid, n-octadecylphosphonic acid, 2-ethylhexylphosphonic acid, methoxymethylphosphonic acid, 3-acryloyloxypropylphosphonic acid, 11-hydroxyundecylphosphonic acid, 1H,1H,2H,2H-perfluorophosphonic acid, 3-aminopropylphosphonic acid, and 4-phosphonobutyric acid, as well as acetic acid, propionic acid, isobutyric acid, nonanoic acid, fluoroacetic acid, $\alpha$-chloropropionic acid, glyoxylic acid, chenodeoxycholic acid, etc., which may be used alone or in a mixture of two or more types.

The method of adsorbing the co-adsorbent to the first electrode 12 is not particularly limited, but similar to the monomolecular hole transport compound, a method of dissolving the co-adsorbent in a solvent before adsorption is preferable. The solvent is not particularly limited, either, but may be, for example, the same as the aforementioned solvents exemplified for the monomolecular hole transport compound. In addition, the co-adsorbent may be adsorbed by immersing the first electrode 12 in a solvent in which the co-adsorbent is dissolved after the monomolecular hole transport compound is once adsorbed to a substrate, or a mixture dissolved in an organic solvent together with the monomolecular

hole transport compound may be used.

[Photoelectric Conversion Layer 14]

The photoelectric conversion layer 14 includes a perovskite compound as described above. Furthermore, the perovskite compound in the photoelectric conversion layer 14 is a perovskite compound formed from a raw material including at least one of formamidine and a salt thereof, as described above. Other than these, the photoelectric conversion layer 14 and the formation method thereof are not particularly limited, but are, for example, as follows.

The perovskite compound contained in the photoelectric conversion layer 14 may be, for example, a compound represented by the following chemical formula (III).

$$X_{\alpha}Y_{\beta}Z_{\gamma} \cdots \qquad \text{(III)}$$

In the chemical formula (III), the ratio of $\alpha:\beta:\gamma$ is, for example, 3:1:1, and $\beta$ and $\gamma$ represent integers greater than 1. X represents, for example, a halogen ion, Y represents, for example, a monovalent cation, and Z represents, for example, a divalent cation. Also, Y represents, for example, an organic compound having an amino group, and Z represents, for example, a metal ion. The perovskite layer (photoelectric conversion layer) 14 is preferably disposed directly adjacent to the electron transport layer 15 without other components interposed therebetween. The ratio of $\alpha:\beta:\gamma$ is not necessarily 3:1:1, and may be, for example, 3:1.05:0.95. The ratio of $\alpha:\beta:\gamma$ is, for example, 3:(0.95 to 1.05):(0.95 to 1.05).

X in the chemical formula (III) is not particularly limited, and can be appropriately selected according to the purpose, and examples include halogen ions such as chlorine, bromine, and iodine. These may be used alone or in combination of two or more types.

Y in the chemical formula (III) includes, for example, alkylamine compound ions (organic compounds having an amino group) such as methylamine, ethylamine, n-butylamine, and formamidine, but is not necessarily organic, and may also include alkali metal ions such as cesium, potassium, and rubidium. The alkylamine compound ions and the alkali metal ions may be respectively used alone or in combination of two or more types. Y can also use, for example, an organic substance (for example, alkylamine compound ion) and an inorganic substance (for example, alkali metal ion) in combination. For example, cesium ion and formamidine may be used in combination.

Z in the chemical formula (III) is not particularly limited, and can be appropriately selected according to the purpose, and examples include metals such as lead, indium, antimony, tin, copper, and bismuth. These may be used alone or in combination of two or more types. Particularly, lead, and among these, the combination of lead and tin is particularly preferable. In addition, the perovskite layer (photoelectric conversion layer) 14 preferably shows a layered perovskite structure in which a layer composed of metal halide and a layer in which organic cation molecules are arranged are alternately laminated. The perovskite layer may contain alkali metal. It is advantageous that the perovskite layer contains at least alkali metal in terms of high output. Examples of the alkali metal include cesium, rubidium, and potassium. Among these, cesium is preferable.

The photoelectric conversion layer 14 may be a perovskite layer formed from the perovskite compound as described above. The method for forming such a perovskite layer is not particularly limited, and can be appropriately selected according to the purpose. For example, a method of applying a solution in which metal halide and alkylamine halide are dissolved or dispersed and then drying the solution can be used. In the disclosure, the photoelectric conversion layer 14 includes the perovskite compound as described above, and the perovskite compound is a perovskite compound formed from a raw material including at least one of formamidine and a salt thereof. The salt of formamidine contained in the raw material is preferably at least one type selected from the group consisting of formamidine formate, formamidine acetate, formamidine thiocyanate, and formamidine chloride. Examples of the salt of formamidine include salts formed from formamidine and an anion. The anion is not particularly limited, but examples include anions formed from carboxylic acids such as fluoroacetic acid, difluoroacetic acid, trifluoroacetic acid, cyanoacetic acid, chloroacetic acid, bromoacetic acid, iodoacetic acid, nitroacetic acid, 2-fluoropropionic acid, pentafluoropropionic acid, and heptafluorobutyric acid; anions formed from dicarboxylic acids such as oxalic acid, pyruvic acid, malonic acid, methylmalonic acid, fluoromalonic acid, succinic acid, and muconic acid; and anions formed from monoester carboxylic acids such as malonic acid monomethyl ester, malonic acid monoethyl ester, and succinic acid monobenzyl ester.

In addition, a two-step precipitation method, for example, can be used as a method for forming the perovskite layer, in which a solution in which metal halide is dissolved or dispersed is applied and dried, and then immersed in a solution in which alkylamine halide is dissolved to form a perovskite compound. Another method is to precipitate crystals by adding a poor solvent (a solvent with low solubility) for the perovskite compound while applying a solution in which metal halide and alkylamine halide are dissolved or dispersed. Furthermore, there is a method of depositing metal halide in a gas filled with methylamine or the like. Furthermore, a method of precipitating crystals by adding a poor solvent for the perovskite compound while applying a solution in which metal halide and alkylamine halide are dissolved or dispersed is particularly preferable. The method for applying these solutions is not particularly limited, and can be appropriately

selected according to the purpose, and examples include an immersion method, a spin coating method, a spray method, a dip method, a roller method, an air knife method, etc. In addition, the method for applying the solution may be a method of precipitating in a supercritical fluid using carbon dioxide or the like. As the method of precipitating crystals by adding the above-mentioned poor solvent, examples of the poor solvent used include hydrocarbons such as n-hexane and n-octane; alcohols such as methanol, ethanol, and 2-propanol; ethers such as diethyl ether and diisopropyl ether; ketones such as acetone and methyl isobutyl ketone; esters such as ethyl acetate, isobutyl acetate, and γ-butyrolactone; nitriles such as acetonitrile and 3-methoxypropionitrile; aromatic hydrocarbon compounds such as benzene, toluene, and chlorobenzene; halogenated solvents such as dichloromethane and chloroform; and fluorinated solvents such as chlorofluorocarbon, hydrochlorofluorocarbon, and hydrofluorocarbon.

The thickness of the photoelectric transport layer 14 (for example, a light absorption layer, such as a perovskite layer) is not particularly limited, but from the viewpoint of further suppressing performance deterioration due to defects or peeling, 50 nm to 1200 nm is preferable, and 200 nm to 00 nm is more preferable.

[Electron Transport Layer 15]

The material used for the electron transport layer 15 is not particularly limited, and can be appropriately selected according to the purpose, but a semiconductor material is preferable. The semiconductor material is not particularly limited, but widely known materials can be used, and examples include an elemental semiconductor, a compound semiconductor, an organic n-type semiconductor, etc., among which a metal oxide semiconductor is most suitable.

The compound semiconductor is not particularly limited, but examples include metal chalcogenide, specifically, oxides of titanium, tin, zinc, iron, tungsten, zirconium, hafnium, strontium, indium, cerium, yttrium, lanthanum, vanadium, niobium, tantalum, etc.; sulfides of cadmium, zinc, lead, silver, antimony, bismuth, etc.; selenides of cadmium, lead, etc.; and tellurides of cadmium, etc. Other compound semiconductors include phosphides of zinc, gallium, indium, cadmium, etc., gallium arsenide, copper-indium-selenide, copper-indium-sulfide, etc.

The organic n-type semiconductor is not particularly limited, but examples include perylene tetracarboxylic anhydride, perylene tetracarboxydiimide compound, naphthalene diimide-bithiophene copolymer, benzobisimidazobenzophenanthroline polymer, $C_{60}$, $C_{70}$, fullerene compound such as PCBM ([6,6]-phenyl-$C_{61}$-butyric acid methyl ester), carbonyl bridge-bithiazole compound, $ALq_3$ (tris(8-quinolinolato)aluminum), triphenylene bipyridyl compound, silole compound, oxadiazole compound, etc. In the disclosure, among the aforementioned materials used for the electron transport layer 15, an organic n-type semiconductor is particularly preferable. In addition, there is no limitation on the crystal form of these semiconductor materials, which can be appropriately selected according to the purpose, and may be single crystal, polycrystalline, or amorphous. The film thickness of the electron transport layer 15 is not particularly limited, and can be appropriately selected according to the purpose, but 5 nm to 1000 nm is preferable, and 10 nm to 700 nm is more preferable.

The formation method of the electron transport layer 15 is not particularly limited, and can be appropriately selected according to the purpose, such as a method of forming a thin film in a vacuum (vacuum film formation method) and a wet film formation method. Examples of the vacuum film formation method include a sputtering method, a pulsed laser deposition method (PLD method), an ion beam sputtering method, an ion assist method, an ion plating method, a vacuum deposition method, an atomic layer deposition method (ALD method), a chemical vapor deposition method (CVD method), etc. Examples of the wet film formation method include a formation method of applying a solvent in which an electron transport material is dissolved, and in the case of an oxide semiconductor, a sol-gel method. The sol-gel method is a method of producing gel from a solution through chemical reaction such as hydrolysis, polymerization, and condensation, and then promoting densification through heat treatment. In the case of using the sol-gel method, the application method of the sol solution is not particularly limited, and can be appropriately selected according to the purpose, such as a dip method, a spray method, a wire bar method, a spin coating method, a roller coating method, a blade coating method, and a gravure coating method, and as wet printing methods, letterpress, offset, gravure, intaglio, rubber plate, screen printing, etc. can be used. In addition, the temperature during heat treatment after applying the sol solution is preferably 80°C or higher, and more preferably 100°C or higher.

[Second Electrode 16]

The second electrode 16 (which may be, for example, a back electrode) is a layer having a function of extracting electrons from the photoelectric conversion layer 14 via the electron transport layer. In addition, the second electrode 16 is, for example, a layer that works as an anode (negative electrode).

The second electrode 16 may be formed directly on the electron transport layer (also called an electron injection layer) 15. In addition, the material of the second electrode 16 is not particularly limited, and for example, the same material as the first electrode 12 can be used. The shape, structure, and size of the second electrode 16 are not particularly limited, and can be appropriately selected according to the purpose. Examples of the material for the second electrode 16 include

metal, a carbon compound, conductive metal oxide, a conductive polymer, etc.

Examples of the metal include platinum, gold, silver, copper, aluminum, etc., and examples of the carbon compound include graphite, fullerene, carbon nanotubes, graphene, etc. Examples of the conductive metal oxide include ITO, FTO, ATO, etc. Examples of the conductive polymer include polythiophene, polyaniline, etc.

The material used for forming the second electrode 16 may be used alone, or two or more types may be used in combination (mixture) or laminated. The second electrode 16 can be formed by appropriately using methods such as coating, laminating, vacuum deposition, CVD, and bonding on the electron transport layer 15, depending on the type of the material used and the type of the hole transport layer 13.

In addition, in the photoelectric conversion element of the disclosure, it is preferable that at least one of the first electrode 12 and the second electrode 16 is substantially transparent. In the case of using the photoelectric conversion element of the disclosure, it is preferable to make the electrode transparent and allow incident light to enter from the electrode side. In this case, it is preferable to use a material that reflects light for the back electrode (the electrode on the opposite side from the transparent electrode, for example, the second electrode). Glass, plastic, a metal thin film, etc. on which metal or conductive oxide is deposited are preferably used. Further, providing an antireflection layer on the incident light side electrode is also an effective means.

Furthermore, the configuration of the photoelectric conversion element of the disclosure is not limited to the configuration of FIG. 1. For example, the support body 11 may be disposed on the opposite side from FIG. 1 (on the upper side of the second electrode 16 in FIG. 1), and the second electrode 16, the electron transport layer 15, the photoelectric conversion layer 14, the hole transport layer 13, and the first electrode 12 may be laminated on the support body 11 in this order. Additionally, for example, as described above, other components may or may not exist between the layers of the support body 11, the first electrode 12, the hole transport layer 13, the photoelectric conversion layer 14, the electron transport layer 15, and the second electrode 16. Although an example in which the first electrode 12 is a transparent electrode and the second electrode 16 is a back electrode has been described, the photoelectric conversion element of the disclosure is not limited thereto. For example, in the photoelectric conversion element of the disclosure, conversely, the first electrode may be a back electrode and the second electrode may be a transparent electrode.

[Encapsulation]

The photoelectric conversion element (for example, solar cell) of the disclosure is preferably encapsulated to protect the device (photoelectric conversion element of the disclosure) from water and oxygen. The structure of the encapsulation is not particularly limited, but may be, for example, the same as the structures of general photoelectric conversion elements (for example, solar cells). Specifically, for example, an encapsulation material may be applied only to the outer peripheral portion of the photoelectric conversion element of the disclosure and covered with glass or a film, an encapsulation material may be applied to the entire surface of the photoelectric conversion element of the disclosure and covered with glass or a film, or an encapsulation material may be applied only to the entire surface of the photoelectric conversion element of the disclosure.

The material of the encapsulation member is not particularly limited, and can be appropriately selected according to the purpose. For example, epoxy resin or acrylic resin is preferably used and cured, but the resin may not be cured or may be only partially cured.

The epoxy resin is not particularly limited, but examples include water-dispersed type, solvent-free type, solid type, thermosetting type, curing agent mixing type, ultraviolet curing type, etc. Among these, thermosetting type and ultraviolet curing type are preferable, and ultraviolet curing type is more preferable. It is possible to perform heating even in the case of ultraviolet curing type, and it is preferable to perform heating even after ultraviolet curing. Specific examples of the epoxy resin include bisphenol A type, bisphenol F type, novolac type, cycloaliphatic type, long-chain aliphatic type, glycidylamine type, glycidyl ether type, glycidyl ester type, etc. These may be used alone or in combination of two or more types. Moreover, it is preferable to mix a curing agent and various additives with epoxy resin as needed. Commercially available epoxy resin compositions can be used in the disclosure. Among these, there are epoxy resin compositions that have been developed and commercialized for solar cell and organic EL element applications, which can be particularly effectively used in the disclosure. Examples of commercially available epoxy resin compositions include TB3118, TB3114, TB3124, TB3125F (manufactured by ThreeBond Co., Ltd.), WorldRock5910, WorldRock5920, WorldRock8723 (manufactured by Kyoritsu Chemical & Co., Ltd.), WB90US(P), WB90US-HV (manufactured by Moresco Corporation), etc.

The acrylic resin is not particularly limited, but for example, acrylic resin that has been developed and commercially available for solar cell and organic EL element applications can be effectively used. Examples of commercially available acrylic resin compositions include TB3035B, TB3035C (manufactured by ThreeBond Co., Ltd.), etc.

The curing agent is not particularly limited, and can be appropriately selected according to the purpose, but examples include amine-based, acid anhydride-based, polyamide-based, and other curing agents. Examples of amine-based curing agent include aliphatic polyamines such as diethylenetriamine and triethylenetetramine, and aromatic

polyamines such as metaphenylenediamine, diaminodiphenylmethane, and diaminodiphenylsulfone. Examples of acid anhydride-based curing agent include phthalic anhydride, tetra- and hexahydrophthalic anhydride, methyltetrahydrophthalic anhydride, methylnadic anhydride, pyromellitic anhydride, het anhydride, dodecenylsuccinic anhydride, etc. Examples of other curing agents include imidazoles and polymercaptan. These may be used alone or in combination of two or more types.

The additive is not particularly limited, and can be appropriately selected according to the purpose. Examples include a filler, a gap agent, a polymerization initiator, a desiccant (moisture absorber), a curing accelerator, a coupling agent, a flexibilizer, a colorant, a flame retardant aid, an antioxidant, an organic solvent, etc. Among these, a filler, a gap agent, a curing accelerator, a polymerization initiator, and a desiccant (moisture absorber) are preferable, and a filler and a polymerization initiator are more preferable. By containing a filler as an additive, it is possible to obtain effects such as suppressing the intrusion of moisture and oxygen, and further reducing volume shrinkage during curing, reducing the amount of outgas during curing or heating, improving mechanical strength, and controlling thermal conductivity and fluidity. Therefore, including a filler as an additive is very effective for maintaining stable output in various environments.

Moreover, regarding the output characteristics and durability of the photoelectric conversion element, not only the influence of intruding moisture and oxygen, but also the influence of outgas generated during curing or heating of the encapsulation member cannot be ignored. In particular, the influence of outgas generated during heating has a significant impact on output characteristics in high-temperature environment storage. By incorporating a filler, a gap agent, and a desiccant into the encapsulation member, these additives themselves can suppress the intrusion of moisture and oxygen, and further reduce the amount of encapsulation member used, thereby achieving an effect of reducing outgas. Incorporating a filler, a gap agent, and a desiccant into the encapsulation member is effective not only in curing but also in the case of storing the photoelectric conversion element in high-temperature environments.

The filler is not particularly limited, and can be appropriately selected according to the purpose. Examples include inorganic fillers such as crystalline or amorphous silica, silicate minerals such as talc, alumina, aluminum nitride, silicon nitride, calcium silicate, calcium carbonate, etc. Among these, hydrotalcite is particularly preferable. Moreover, these may be used alone or in combination of two or more types.

The average primary particle diameter of the filler is not particularly limited, but is preferably 0.1 μm or more and 10 μm or less, and more preferably 1 μm or more and 5 μm or less. In the case of the average primary particle diameter of the filler being within the above preferable range, the effect of suppressing the intrusion of moisture and oxygen can be sufficiently obtained, the viscosity becomes appropriate, adhesion to the substrate and defoaming properties are improved, and it is also effective for controlling the width of the encapsulation part and workability.

The content of the filler is preferably 10 parts by mass or more and 90 parts by mass or less, and more preferably 20 parts by mass or more and 70 parts by mass or less, relative to the entire encapsulation member (100 parts by mass). In the case of the content of the filler being within the above preferable range, the effect of suppressing the intrusion of moisture and oxygen can be sufficiently obtained, the viscosity also becomes appropriate, and adhesion and workability also improve.

The gap agent is also called a gap control agent or spacer agent. By including a gap agent as an additive, it is possible to control the gap of the encapsulation part. For example, in the case of applying an encapsulation member on a first substrate or a first electrode, and placing a second substrate thereon for encapsulation, mixing the encapsulation member with a gap agent causes the gap of the encapsulation part to align with the size of the gap agent, making it possible to easily control the gap of the encapsulation part.

The gap agent is not particularly limited, but for example, gap agents that are granular with uniform particle diameter and have high solvent resistance and heat resistance are preferable, which can be appropriately selected according to the purpose. Gap agents having high affinity with epoxy resin and a spherical particle shape are preferable. Specifically, glass beads, silica fine particles, organic resin fine particles, and the like are preferable. These may be used alone or in combination of two or more types. The particle diameter of the gap agent can be selected according to the gap of the encapsulation part to be set, but is preferably 1 μm or more and 100 μm or less, and more preferably 5 μm or more and 50 μm or less.

The polymerization initiator is not particularly limited, and examples include polymerization initiators that initiate polymerization using heat or light, which can be appropriately selected according to the purpose. For example, a thermal polymerization initiator, a photopolymerization initiator, etc. can be listed. The thermal polymerization initiator is a compound that generates active species such as radicals or cations by heating, and examples include an azo compound such as 2,2'-azobisisobutyronitrile (AIBN), peroxide such as benzoyl peroxide (BPO), etc. As the thermal cationic polymerization initiator, benzenesulfonic acid esters, alkylsulfonium salts, and the like are used. In the case of epoxy resin, a photocationic polymerization initiator is preferably used as the photopolymerization initiator. In the case of mixing a photocationic polymerization initiator with epoxy resin and performing light irradiation, the photocationic polymerization initiator decomposes to generate acid, the acid causes polymerization of the epoxy resin, and the curing reaction proceeds. The photocationic polymerization initiator has effects such as small volume shrinkage during curing, no oxygen inhibition, and high storage stability.

Examples of the photocationic polymerization initiator include an aromatic diazonium salt, an aromatic iodonium salt, an aromatic sulfonium salt, a metallocene compound, a silanol-aluminum complex, etc. Additionally, a photoacid generator having a function of generating acid by light irradiation can also be used as the polymerization initiator. The photoacid generator acts as an acid that initiates cationic polymerization, and examples include onium salts such as ionic sulfonium salt-based or iodonium salt-based compounds composed of a cation part and an anion part. These may be used alone or in combination of two or more types.

The addition amount of the polymerization initiator is not particularly limited, and may differ depending on the materials used, but is preferably 0.5 parts by mass or more and 10 parts by mass or less, and more preferably 1 part by mass or more and 5 parts by mass or less, relative to the entire encapsulation member (100 parts by mass). In the case of the addition amount being within the above preferable range, curing can proceed appropriately, the remaining of uncured materials can be reduced, and excessive outgas can be prevented.

The desiccant (also referred to as a moisture absorbent) is a material having a function of physically or chemically adsorbing moisture, and including the desiccant in the encapsulation member can further enhance moisture resistance and reduce the influence of outgas. The desiccant is not particularly limited, and can be appropriately selected according to the purpose, but particulate forms are preferable, examples of which include inorganic water-absorbing materials such as calcium oxide, barium oxide, magnesium oxide, magnesium sulfate, sodium sulfate, calcium chloride, silica gel, molecular sieve, zeolite, etc. Among these, zeolite having a large moisture absorption amount is preferable. These may be used alone or in combination of two or more types.

The curing accelerator (also referred to as a curing catalyst) is a material that accelerates the curing rate and is mainly used for thermosetting epoxy resin. The curing accelerator is not particularly limited, and can be appropriately selected according to the purpose. Examples include tertiary amines or tertiary amine salts such as DBU (1,8-diazabicyclo(5,4,0)-undecene-7) and DBN (1,5-diazabicyclo(4,3,0)-nonene-5), imidazole-based compounds such as 1-cyanoethyl-2-ethyl-4-methylimidazole and 2-ethyl-4-methylimidazole, and phosphines or phosphonium salts such as triphenylphosphine and tetraphenylphosphonium tetraphenylborate. These may be used alone or in combination of two or more types.

The coupling agent is not particularly limited as long as the coupling agent is a material having an effect of enhancing molecular bonding force, and can be appropriately selected according to the purpose, such as a silane coupling agent. Specific examples of the silane coupling agent include 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, 3-methacryloxypropyltrimethoxysilane, etc. These may be used alone or in combination of two or more types.

In the disclosure, for example, a sheet-shaped adhesive can be used. The sheet-shaped adhesive, for example, has a resin layer formed in advance on a sheet, and glass or a film with high gas barrier properties can be used for the sheet. In addition, the sheet may be formed only with encapsulation resin. It is also possible to attach the sheet-shaped adhesive onto an encapsulation film. It is also possible to form a structure with a hollow part on the encapsulation film, and then bond the film with a device.

In the case of encapsulation using the encapsulation film, the encapsulation film is disposed to face the support body so as to sandwich the photoelectric conversion device. The substrate of the encapsulation film is not particularly limited in terms of the shape, structure, size, and type, and can be appropriately selected according to the purpose. The encapsulation film has a barrier layer formed on the surface of the substrate to prevent the passage of moisture and oxygen, and may be formed on only one surface of the substrate or on both surfaces.

The barrier layer may be composed of a material having, for example, metal oxide, metal, and a mixture formed from a polymer and metal alkoxide, as main components. Examples of the metal oxide include aluminum oxide, silicon oxide, aluminum, etc. Examples of the polymer include polyvinyl alcohol, polyvinylpyrrolidone, methylcellulose, etc. Examples of the metal alkoxide include tetraethoxysilane, triisopropoxyaluminum, 3-glycidoxypropyltrimethoxysilane, 3-mercaptopropyltrimethoxysilane, 3-isocyanatepropyltriethoxysilane, etc.

The barrier layer may be, for example, transparent or opaque. Additionally, the barrier layer may be a single layer formed by the combination of the above materials, or may have multiple laminated structures. As for the formation method of the barrier layer, known methods can be used, and coating methods such as vacuum film formation like a sputtering method, a dipping method, a roll coating method, a screen printing method, a spray method, a gravure printing method, etc. can be used.

[Wiring]

The photoelectric conversion element (for example, solar cell) of the disclosure preferably has lead wires (wiring) connected to the electrode and the back electrode in order to efficiently extract the current generated by light. The lead

wires are connected to, for example, the first electrode and the second electrode using conductive materials such as solder, silver paste, and graphite. The conductive materials may be used alone or in a mixture or laminated structure of two or more types. Additionally, the portions where the lead wires are attached may be covered with acrylic resin or epoxy resin from the viewpoint of physical protection.

Lead wires are a general term for electric wires electrically connecting power sources, electronic components, etc. in electric circuits, and examples include vinyl wires, enamel wires, etc.

[Applications]

The applications and usage methods of the photoelectric conversion element of the disclosure are not particularly limited, and can be widely used in applications similar to, for example, general photoelectric conversion elements (for example, general solar cells). The photoelectric conversion element (for example, solar cell) of the disclosure can be applied to power supply devices through a combination with, for example, circuit boards that control the generated current. Examples of devices that utilize power supply devices include electronic desktop calculators and solar radio-controlled wristwatches. It is also possible to apply the solar cell of the disclosure as a power supply device to mobile phones, electronic paper, temperature and humidity meters, etc. The photoelectric conversion element of the disclosure can also be applied to nighttime use through a combination with auxiliary power sources or secondary batteries to extend the continuous usage time of rechargeable or dry battery-type electrical appliances, and can also be used as a self-contained power source that does not require battery replacement or power supply wiring.

## Examples

Examples of the disclosure will be described hereinafter. However, the disclosure is not limited to the following examples.

[Example 1]

The photoelectric conversion element of the disclosure having the configuration shown in FIG. 1 was produced (manufactured) as follows.

First, an ITO glass substrate having an ITO electrode laminated on a glass substrate was prepared. This ITO glass substrate is a laminate of the substrate 11 and the first electrode 12, in which the glass substrate corresponds to the substrate 11 and the ITO electrode corresponds to the first electrode 12. On the surface of the ITO glass substrate on the ITO electrode (first electrode 12) side, a DMF solution in which a compound represented by the following chemical formula 3PATAT (0.1 mmol/L) and 4-phosphonobutyric acid (12 mmol/L) were dissolved was placed and applied using a spin coater (3,000 rpm, 30 seconds). Subsequently, heat drying was performed on a hot plate at 100°C for 10 minutes to form a monomolecular hole transport layer (hole transport layer 13) on the first electrode. Next, cesium iodide (0.738 g), formamidine iodide (7.512 g), methylamine bromide (0.905 g), lead iodide (25.17 g), and formamidine acetate (2.27 g) were dissolved in N,N-dimethylformamide (DMF, 40.0 mL) and dimethyl sulfoxide (DMSO, 12.0 mL), and the dissolved solution was formed into a film on the hole transport layer 13 of the substrate using spin coating (3,000 rpm). Thereafter, heating was performed at 150°C for 10 minutes to obtain a perovskite layer as the photoelectric conversion layer 14. Furthermore, a 1:1 mixed solution (0.5 mg/mL) of 2-propanol and toluene in which ethylenediamine diiodide was dissolved was formed into a film on the perovskite layer using spin coating, and film formation was performed at 120°C for 10 minutes. Subsequently, 20 nm of $C_{60}$ (electron transport layer 15), bathocuproine (BCP, 8 nm) (electron injection layer), and finally Ag (80 nm, second electrode 16) were formed into films by vacuum deposition to obtain a photoelectric conversion element.

[Chemical Formula 3PATAT]

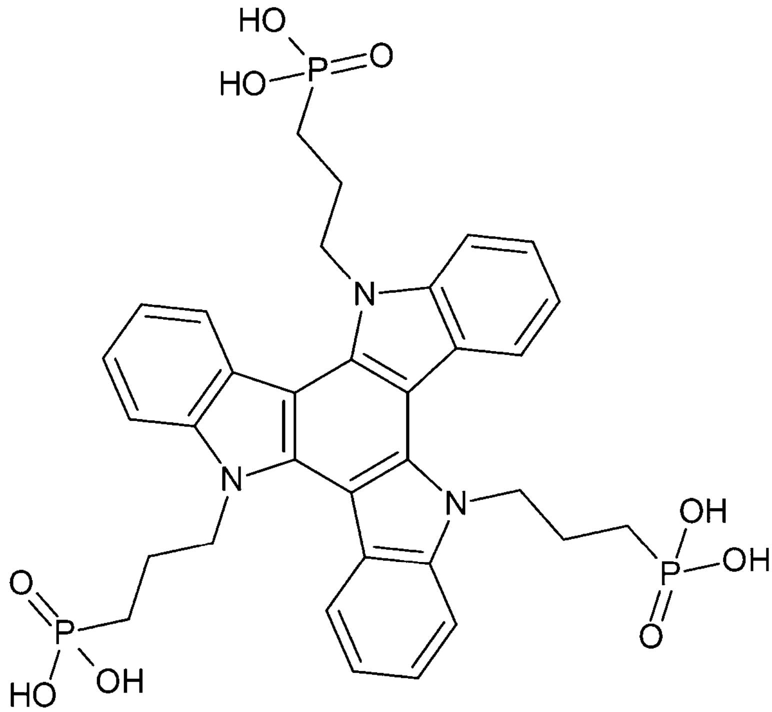

3PATAT

The compound represented by the chemical formula 3PATAT was synthesized as follows.

<Synthesis Example of 3-PATAT>

First, a compound represented by the following chemical formula (IV) was synthesized by the following procedure. That is, first, oxindole (10.7 g, 80.55 mmol) and phosphorus oxychloride (50 mL) were placed in a flask and heated and stirred at 100°C for 14 hours under an argon atmosphere. The reaction solution after heating and stirring was cooled to room temperature, and was poured into ice water to stop the reaction. Thereafter, neutralization was performed with an aqueous sodium hydroxide solution, and the precipitate was filtered. This precipitate was purified by silica gel column chromatography (eluent: dichloromethane only) and further recrystallized with acetone to obtain 5.8 g (11.11 mmol, yield 41%) of compound (IV) as pale yellow crystals.

[Chemical Formula IV]

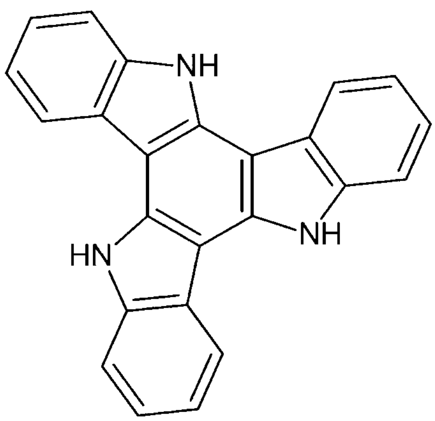

(IV)

The compound (IV) (1.73 g) and DMF (50 ml) were placed in a three-necked flask, and sodium hydride (360 mg) was slowly added while stirring at room temperature under an argon gas stream. Next, diethyl (3-bromopropyl)phosphonate (2.9 mL) was added dropwise, and after completion of the dropwise addition, the mixture was heated and stirred at 70°C. After continuing heating and stirring for 36 hours, the reaction solution was poured into water to stop the reaction, and extraction was performed three times with dichloromethane. The extracted organic layer was dried with magnesium sulfate, and the solvent was distilled off. The obtained residue was produced by silica gel column chromatography (eluent: ethyl acetate/methanol=1/0 to 1/1 (volume ratio)) to obtain 2.17 g of a compound represented by the following chemical formula (V). The yield was 49% based on compound (IV) as the raw material.

[Chemical Formula V]

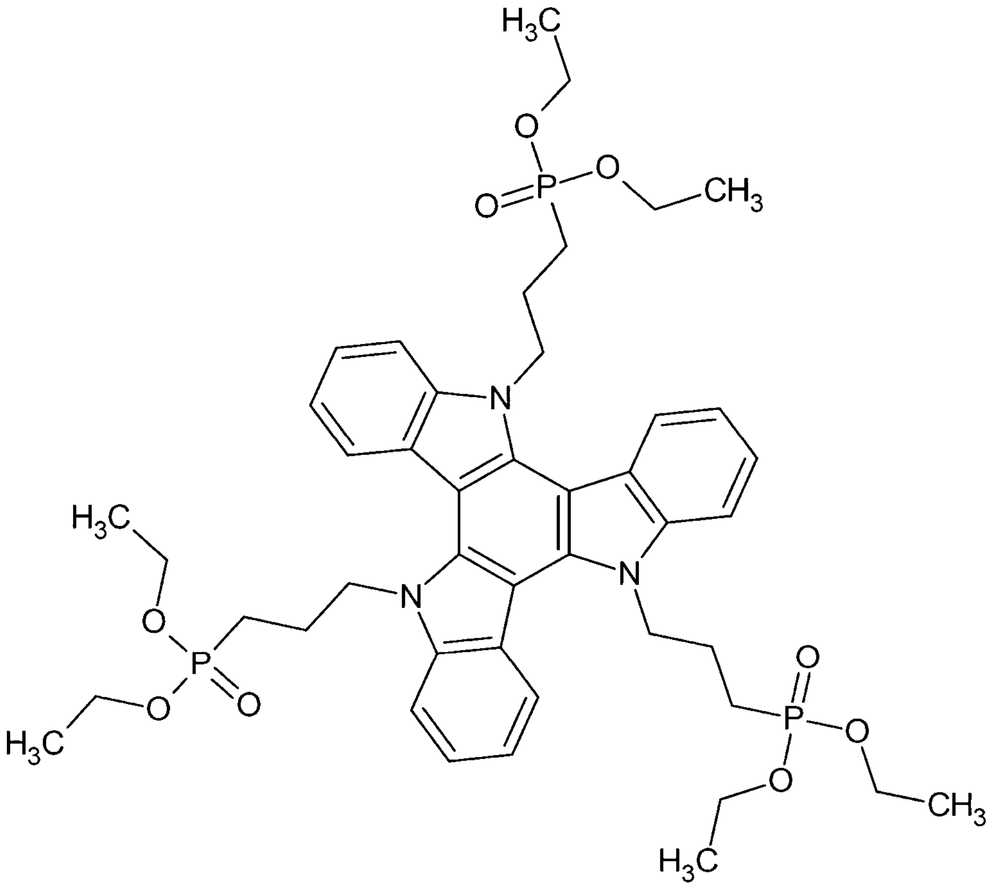

(V)

The compound (V) (200 mg) and dichloromethane (6 mL) were placed in a three-necked flask, and trimethylsilyl bromide (0.30 mL) was slowly added under an argon gas stream while stirring at room temperature. After 14 hours, the reaction solution was concentrated under reduced pressure to obtain a solid residue. This crystal was repeatedly reprecipitated with a mixed solvent of dichloromethane and methanol (5/1, volume ratio) and washed with dichloromethane to obtain 125 mg of 3PATAT. The yield was 77% based on compound (V) as the raw material. For this 3PATAT, $^{1}$H NMR, $^{13}$C NMR, $^{31}$P NMR, and HRMS (MALDI) were measured. The measurement results are shown below. Additionally, charts for $^{1}$H NMR, $^{13}$C NMR, and $^{31}$P NMR are shown in FIG. 2 to FIG. 4.

$^{1}$HNMR(400MHz,DMSO-$d_6$):δ8.30-8.28(d,J=8.OHz,3H),7.91-7.89(d,J=8.0Hz,3H),7.51-7.47(t,J=7.2Hz,3H),7.41-7.37(t,J=7.6Hz,3H),5.08-5.05(t,J=6.8Hz,6H),1.95-1.85(m,6H),1.13-1.04(m,6H). $^{13}$CNMR(101MHz,DMSO-$d_6$):δ141.0,137.8,123.2,122.5,121.5,120.4,111.4,103.2,46.8,46.6,25.2,23.8,23.0,22.9. $^{31}$PNMR(162MHz,DMSO-$d_6$):δ24.75. HRMS(MALDI)(m/z): $[M]^+$calcd. for$C_{33}H_{36}N_3O_9P_3$,711.1664;found,711.1653.

[Evaluation of Solar Cell Characteristics]

The photoelectric conversion characteristics of the photoelectric conversion element produced in Example 1 were measured by a method in accordance with the output measurement method for silicon crystalline solar cells of JIS C8913:1998. The results are shown in Table 1 below. A solar simulator (SMO-250III manufactured by Bunkoukeiki Co., Ltd.) combined with an air mass filter equivalent to AM1.5G was adjusted to a light intensity of 100 mW/cm$^2$ with a secondary standard Si solar cell as a measurement light source, and I-V curve characteristics were measured using a source meter (Model 2400 General Purpose Source Meter manufactured by Keithley Instruments Inc.) while irradiating light to the test sample of the perovskite type solar cell (the encapsulated device produced in Example 1). Using the short-circuit current (Isc), open-circuit voltage (Voc), and fill factor (FF) obtained from the I-V curve characteristic measurement based on the measurement, the short-circuit current density (Jsc) and photoelectric conversion efficiency (PCE) were calculated based on the following Formula 1 and Formula 2. Additionally, after continuously irradiating a solar simulator

combined with an air mass filter equivalent to AM1.5G for 100 hours in a glove box, the photoelectric conversion efficiency was calculated in the same manner as described above.

Formula 1: Short-circuit current density (Jsc; $mA/cm^2$)=Isc (mA)/effective light-receiving area S ($cm^2$) Formula 1:

Photoelectric conversion efficiency (PCE; %)=Voc (V)$\times$Jsc ($mA/cm^2$)$\times$FF$\times$100/100 ($mW/cm^2$) Formula 2:

[Example 2]

A photoelectric conversion element was produced (manufactured) and evaluated in the same manner as Example 1, except that formamidine acetate (2.27 g) in Example 1 was changed to formamidine formate (2.06 g). The results are shown in Table 1 below.

[Example 3]

A photoelectric conversion element was produced (manufactured) and evaluated in the same manner as Example 1, except that formamidine acetate (2.27 g) in Example 1 was changed to formamidine thiocyanate (2.25 g). The results are shown in Table 1 below.

[Example 4]

A photoelectric conversion element was produced (manufactured) and evaluated in the same manner as Example 1, except that formamidine acetate (2.27 g) in Example 1 was changed to formamidine chloride (1.76 g). The results are shown in Table 1 below.

[Example 5]

A photoelectric conversion element was produced (manufactured) and evaluated in the same manner as Example 1, except that the DMF solution in which the compound represented by (I) (0.1 mmol/L) and 4-phosphonobutyric acid (12 mmol/L) were dissolved in Example 1 was changed to the compound represented by (II) (0.1 mmol/L). The results are shown in Table 1 below.

[Example 6]

A photoelectric conversion element was produced (manufactured) and evaluated in the same manner as Example 1, except that the DMF solution in which the compound represented by (I) (0.1 mmol/L) and 4-phosphonobutyric acid (12 mmol/L) were dissolved in Example 1 was changed to the compound represented by (II) (0.1 mmol/L) and 3-aminopropylphosphonic acid. The results are shown in Table 1 below.

[Example 7]

A photoelectric conversion element was produced (manufactured) and evaluated in the same manner as Example 1, except that N,N-dimethylformamide (DMF, 40.0 mL) and dimethyl sulfoxide (DMSO, 12.0 mL) in Example 1 were changed to N,N-dimethylformamide (DMF, 30.0 mL) and tetrahydrofurfuryl alcohol (22.0 mL). The results are shown in Table 1 below.

[Example 8]

A photoelectric conversion element was produced (manufactured) and evaluated in the same manner as Example 1, except that N,N-dimethylformamide (DMF, 40.0 mL) and dimethyl sulfoxide (DMSO, 12.0 mL) in Example 1 were changed to N-methyl-2-pyrrolidone (NMP, 20.0 mL) and tetrahydrofurfuryl alcohol (32.0 mL). The results are shown in Table 1 below.

[Comparative Example 1]

A photoelectric conversion element was produced (manufactured) and evaluated in the same manner as Example 1, except that formamidine acetate (2.27 g) in Example 1 was not used. The results are shown in Table 1 below.

[Comparative Example 2]

A photoelectric conversion element was produced (manufactured) and evaluated in the same manner as Example 1, except that formamidine acetate (2.27 g) in Example 1 was changed to methylamine chloride (1.47 g). The results are shown in Table 1 below.

[Comparative Example 3]

When forming the hole transport layer, the DMF solution in which the compound 3PATAT (one type of the compound represented by the chemical formula (I), 0.1 mmol/L) and 4-phosphonobutyric acid (12 mmol/L) were dissolved in Example 1 was not used. Instead of the solution, PEDOT:PSS (Heraeus, Clevios P VP. Al 4083) was formed into a film on ITO by spin coating (3,000 rpm), and dried at 140°C for 20 minutes to form a hole transport layer. A photoelectric conversion element was produced (manufactured) and evaluated in the same manner as Example 1 except for the formation of the hole transport layer. The results are shown in Table 1 below.

[Example 9]

A photoelectric conversion element was produced (manufactured) and evaluated in the same manner as Example 1, except that formamidine acetate (2.27 g) in Example 1 was changed to formamidine fluoroacetate (2.66 g). The results are shown in Table 2 below.

[Example 10]

A photoelectric conversion element was produced (manufactured) and evaluated in the same manner as Example 1, except that formamidine acetate (2.27 g) in Example 1 was changed to formamidine difluoroacetate (3.05 g). The results are shown in Table 2 below.

[Example 11]

A photoelectric conversion element was produced (manufactured) and evaluated in the same manner as Example 1, except that formamidine acetate (2.27 g) in Example 1 was changed to formamidine trifluoroacetate (3.45 g). The results are shown in Table 2 below.

[Example 12]

A photoelectric conversion element was produced (manufactured) and evaluated in the same manner as Example 1, except that formamidine acetate (2.27 g) in Example 1 was changed to formamidine cyanoacetate (2.82 g). The results are shown in Table 2 below.

[Example 13]

A photoelectric conversion element was produced (manufactured) and evaluated in the same manner as Example 1, except that formamidine acetate (2.27 g) in Example 1 was changed to formamidine iodoacetate (5.01 g). The results are shown in Table 2 below.

[Example 14]

A photoelectric conversion element was produced (manufactured) and evaluated in the same manner as Example 1, except that formamidine acetate (2.27 g) in Example 1 was changed to formamidine malonate (3.23 g). The results are shown in Table 2 below.

[Example 15]

A photoelectric conversion element was produced (manufactured) and evaluated in the same manner as Example 1, except that formamidine acetate (2.27 g) in Example 1 was changed to formamidine fluoromalonate (3.62 g). The results are shown in Table 2 below.

[Example 16]

A photoelectric conversion element was produced (manufactured) in the same manner as Example 1, except that formamidine acetate (2.27 g) in Example 1 was changed to formamidine malonate monoethyl ester (3.84 g), and the photoelectric conversion efficiency was measured. The solar cell characteristic results are shown in Table 2 below.

[Table 1]

| | Initial Characteristics | | | |
|---|---|---|---|---|
| | Voc V | Jsc mA/cm2 | FF | PCE % |
| Example 1 | 1.09 | 21.8 | 80.8 | 19.2 |
| Example 2 | 1.08 | 21.7 | 80.7 | 18.9 |
| Example 3 | 1.09 | 21.9 | 81.1 | 19.4 |
| Example 4 | 1.07 | 22.0 | 80.7 | 19.0 |
| Example 5 | 1.06 | 21.6 | 80.9 | 18.5 |
| Example 6 | 1.05 | 22.1 | 80.7 | 18.7 |
| Example 7 | 1.08 | 21.7 | 80.1 | 18.8 |
| Example 8 | 1.05 | 22.3 | 81.1 | 19.0 |
| Comparative Example 1 | 0.56 | 16.8 | 35.3 | 3.3 |
| Comparative Example 2 | 0.95 | 19.5 | 57.8 | 10.7 |
| Comparative Example 3 | 0.85 | 17.7 | 70.2 | 10.6 |

[Table 2]

| | Initial Characteristics | | | |
|---|---|---|---|---|
| | Voc V | Jsc mA/cm2 | FF | PCE % |
| Example 9 | 1.11 | 22.2 | 79.9 | 19.7 |
| Example 10 | 1.11 | 22.1 | 79.8 | 19.6 |
| Example 11 | 1.10 | 21.9 | 78.9 | 19.0 |
| Example 12 | 1.09 | 21.8 | 79.3 | 18.8 |
| Example 13 | 1.08 | 21.7 | 79.2 | 18.6 |
| Example 14 | 1.09 | 21.5 | 79.5 | 18.7 |
| Example 15 | 1.10 | 21.9 | 79.7 | 19.2 |
| Example 16 | 1.08 | 21.1 | 78.8 | 18.0 |

As can be seen from the differences between Examples 1 to 16 and Comparative Examples 1 and 2 in Tables 1 and 2 above, it was confirmed that, according to the disclosure, a photoelectric conversion element with good characteristics can be obtained by using at least one of formamidine and a salt thereof as an additive in forming the perovskite layer. Further, from the differences between Examples 1 to 16 and Comparative Example 3 in Tables 1 and 2 above, it was confirmed that a photoelectric conversion element with good characteristics can be obtained by using a hole transport material (monomolecular hole transport compound) that forms a monomolecular film represented by the chemical formula (I) in the hole transport layer and using at least one of formamidine and a salt thereof as an additive in forming the perovskite layer.

The reason why a photoelectric conversion element with good characteristics can be obtained by not only using a monomolecular hole transport compound in the hole transport layer but also using a formamidine derivative in forming the perovskite layer has not been clearly elucidated. As the reason, for example, since the formation of the perovskite layer is greatly affected by the underlying layer, it is considered that good characteristics could be obtained by combining these two elements (using a monomolecular hole transport compound in the hole transport layer and mixing a formamidine derivative in forming the perovskite layer).

As described above, it was confirmed by the examples that good solar cell characteristics can be obtained by using the configuration of the photoelectric conversion element of the disclosure.

The disclosure has been described above using embodiments and examples. However, the disclosure is not limited to the embodiments and examples described above, and can be arbitrarily and appropriately combined, modified, or selectively adopted as needed within the scope that does not depart from the spirit of the disclosure.

<Supplementary Notes>

Part or all of the above embodiments and examples can also be described as the following supplementary notes, but are not limited to the following.

(Supplementary Note 1)

A photoelectric conversion element, including a first electrode, an electron transport layer, a photoelectric conversion layer, a hole transport layer, and a second electrode laminated in this order, wherein

the hole transport layer includes a compound represented by the following chemical formula (I),
the photoelectric conversion layer includes a perovskite compound, and the perovskite compound is a perovskite compound formed from a raw material including at least one of formamidine and a salt thereof.

[Chemical Formula I]

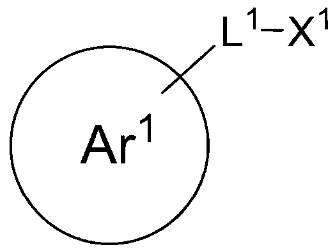

(I)

In the chemical formula (I),

$Ar^1$ is a structure including an aromatic ring, and may or may not include a heteroatom among atoms constituting the aromatic ring,
$Ar^1$ may or may not have a substituent other than $-L^1-X^1$,
$-L^1-X^1$ may be single or multiple, and in the case of being multiple, each $L^1$ may be the same as or different from each other and each $X^1$ may be the same as or different from each other,
each $L^1$ is an atomic group that bonds $Ar^1$ and $X^1$, or is a covalent bond, and
each $X^1$ is a group capable of exchanging charges with the first electrode.

(Supplementary Note 2)

The photoelectric conversion element according to Supplementary Note 1, wherein $Ar^1$ in the chemical formula (I) includes a nitrogen atom among the atoms constituting the aromatic ring.

(Supplementary Note 3)

The photoelectric conversion element according to Supplementary Note 1 or 2, wherein $L^1$ in the chemical formula (I) is a divalent linking group that bonds $Ar^1$ and $X^1$, or is a single bond.

(Supplementary Note 4)

The photoelectric conversion element according to any one of Supplementary Notes 1 to 3, wherein $X^1$ in the

chemical formula (I) is a group capable of forming a chemical bond or a hydrogen bond with the first electrode.

(Supplementary Note 5)

The photoelectric conversion element according to any one of Supplementary Notes 1 to 4, wherein $X^1$ in the chemical formula (I) is each independently a dihydroxyphosphoryl group, a carboxyl group, a sulfo group, a boronic acid group, a trihalogenated silyl group, a trialkoxysilyl group, or a trihydroxysilyl group.

(Supplementary Note 6)

The photoelectric conversion element according to any one of Supplementary Notes 1 to 5, wherein the compound represented by the chemical formula (I) has three or more of the substituent $L^1$-$X^1$.

(Supplementary Note 7)

The photoelectric conversion element according to any one of Supplementary Notes 1 to 6, wherein in the chemical formula (I), the number of -$L^1$-$X^1$ is in a range of 1 to 4.

(Supplementary Note 8)

The photoelectric conversion element according to any one of Supplementary Notes 1 to 7, wherein in the chemical formula (I), each $X^1$ is respectively a phosphonic acid group ($-P=O(OH)_2$), a carboxy group (-COOH), a sulfo group ($-SO_3H$), a boronic acid group ($-B(OH)_2$), a trihalogenated silyl group ($-SiX_3$, where X is a halo group), or a trialkoxysilyl group ($-Si(OR)_3$, where R is an alkyl group).

(Supplementary Note 9)

The photoelectric conversion element according to any one of Supplementary Notes 1 to 8, wherein in the chemical formula (I), the $Ar^1$ is represented by the following chemical formula (I-1).

[Chemical Formula I-1]

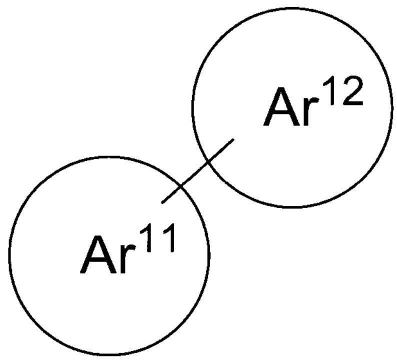

(I − 1)

In the chemical formula (I-1),

$Ar^{11}$ is an atomic group including a cyclic structure, and the cyclic structure may be an aromatic ring or a non-aromatic ring, may be a monocyclic ring, a condensed ring, or a spiro ring, and may or may not include a heteroatom among atoms constituting the ring,
$Ar^{12}$ is an aromatic ring, and may or may not include a heteroatom among the atoms constituting the ring,
$Ar^{12}$ may share one or more atoms with $Ar^{11}$ and be integrated with $Ar^{11}$, and
$Ar^{12}$ may be single or multiple, and in the case of being multiple, $Ar^{12}$ may be the same as or different from each other.

The number of $Ar^{12}$ is not particularly limited, but may be, for example, in a range of 1 to 4.

(Supplementary Note 10)

The photoelectric conversion element according to any one of Supplementary Notes 1 to 9, wherein in the chemical formula (I-1), the $Ar^{11}$ is represented by any one of the following chemical formulas (a1) to (a10).

[Chemical Formulas a1 to a10]

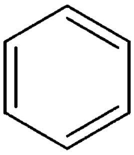

(a 1)

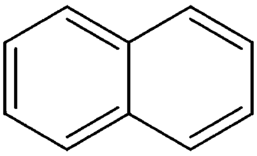

(a 2)

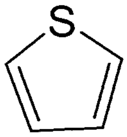

(a 3)

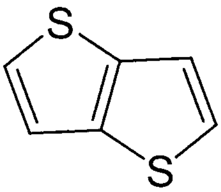

(a 4)

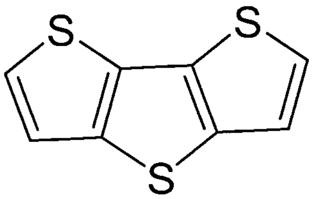

(a 5)

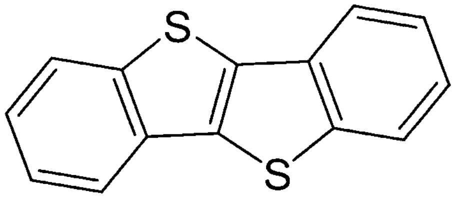

(a 6)

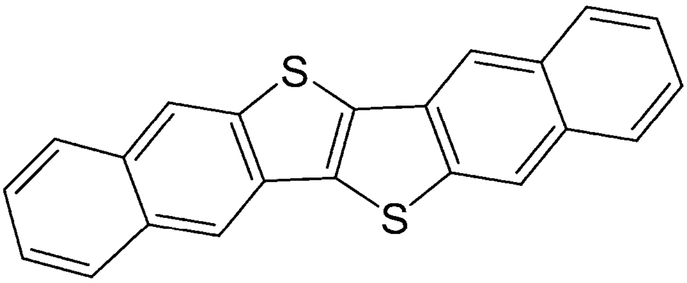

(a 7)

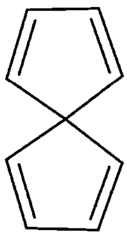

(a 8)

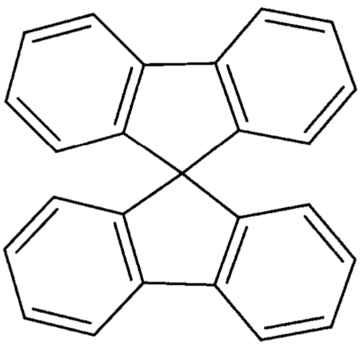

(a 9)

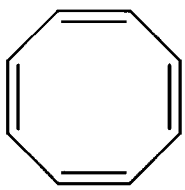

(a 1 0)

(Supplementary Note 11)

The photoelectric conversion element according to any one of Supplementary Notes 1 to 10, wherein in the chemical formula (I-1), each $Ar^{12}$ is represented by the following chemical formula (b).

[Chemical Formula b]

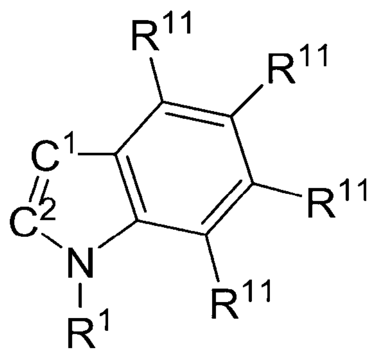

(b)

In the chemical formula (b),

carbon atoms $C^1$ and $C^2$ also serve as part of the atoms constituting the cyclic structure in the $Ar^{11}$ in the chemical formula (I-1),
the $R^1$ is a hydrogen atom, $X^1$ in the chemical formula (I), or a substituent, the substituent may or may not include a hydrogen atom, and at least one of the hydrogen atoms in the substituent may be substituted with $X^1$ in the chemical formula (I),
each of the $R^{11}$ may be the same as or different from each other, and each is a hydrogen atom or a substituent, or two adjacent $R^{11}$ may form a condensed ring together with the benzene ring to which the $R^{11}$ are bonded, and
each of the $R^{11}$ may or may not further have a substituent.

(Supplementary Note 12)

The photoelectric conversion element according to Supplementary Note 11, wherein the chemical formula (b) is represented by any one of the following chemical formulas (b1) to (b7).

[Chemical Formulas b1 to b7]

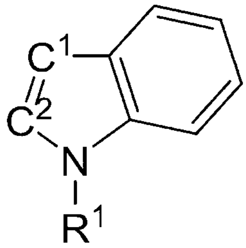

(b 1)

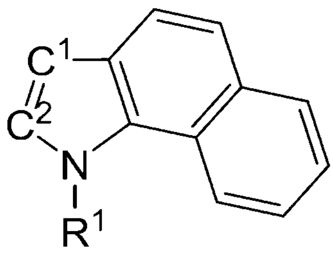

(b 2)

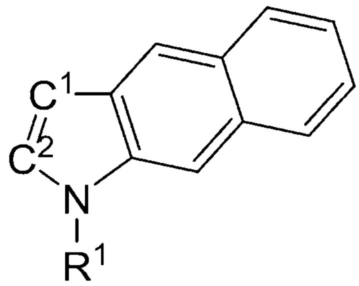

(b 3)

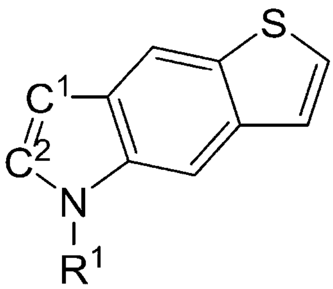

(b 4)

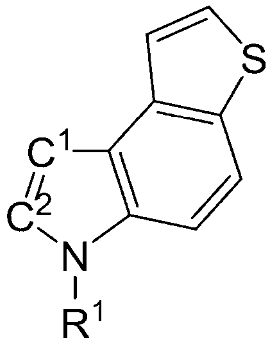

(b 5)

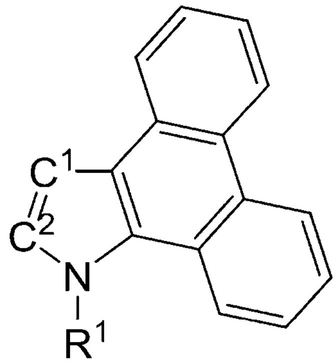

(b 6)

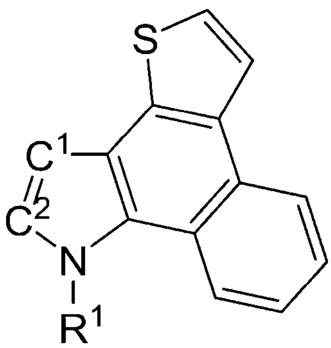

(b 7)

In the chemical formulas (b1) to (b7), $C^1$, $C^2$, and $R^1$ are respectively the same as those in the chemical formula (b).

(Supplementary Note 13)

The photoelectric conversion element according to any one of Supplementary Notes 1 to 12, wherein the compound represented by the chemical formula (I) is a compound represented by any one of the following chemical formulas A-1 to A-23.

[Chemical Formulas A1A4]

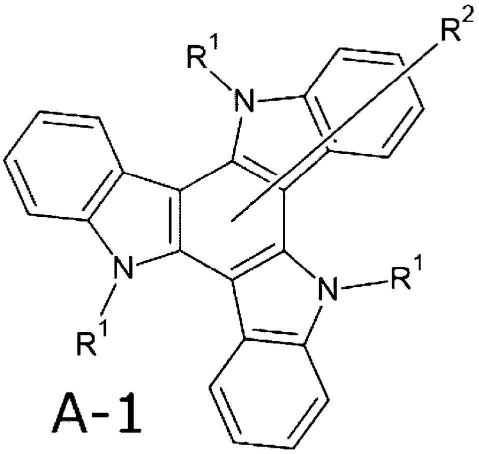

A-1

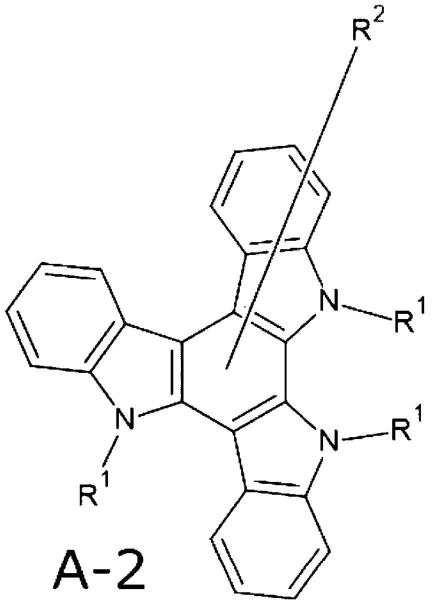

A-2

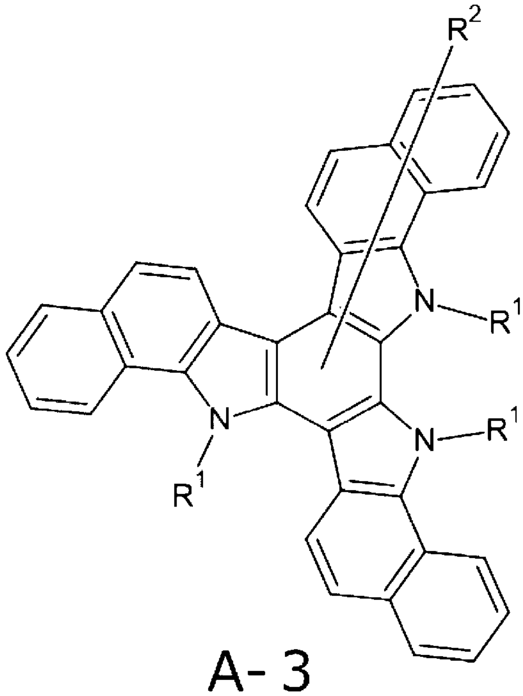

A-3

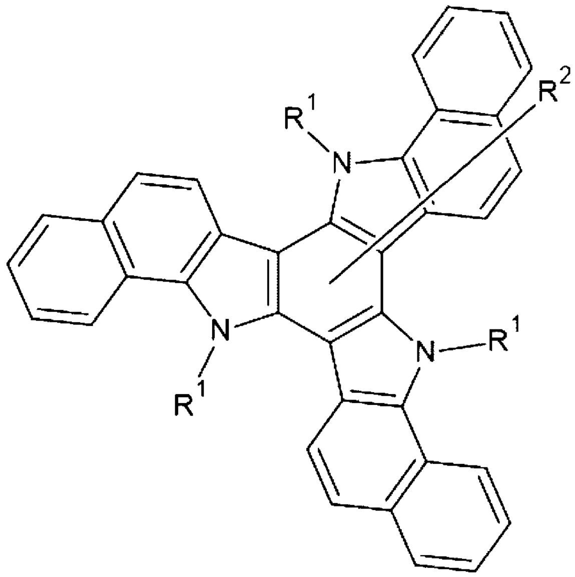

A-4

[Chemical Formulas A5A8]

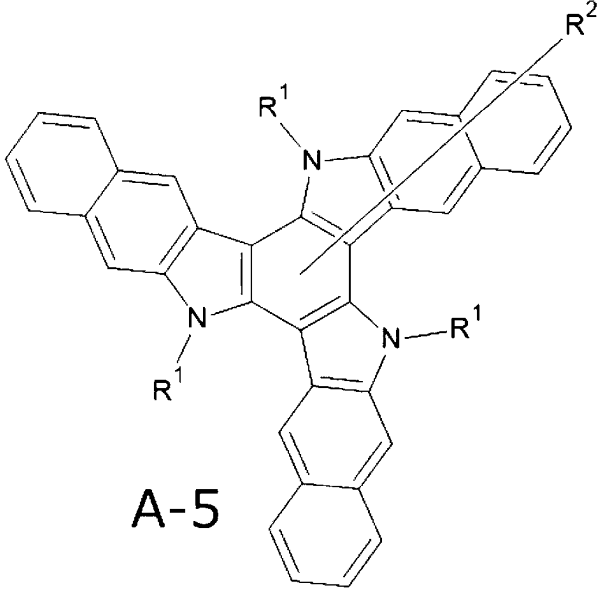

A-5

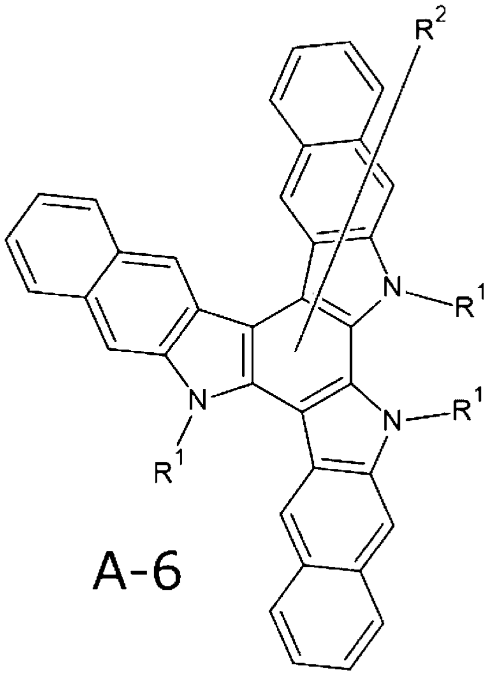

A-6

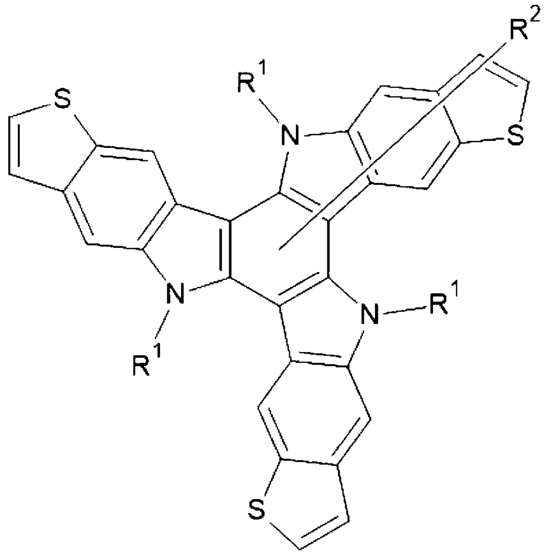

A-7

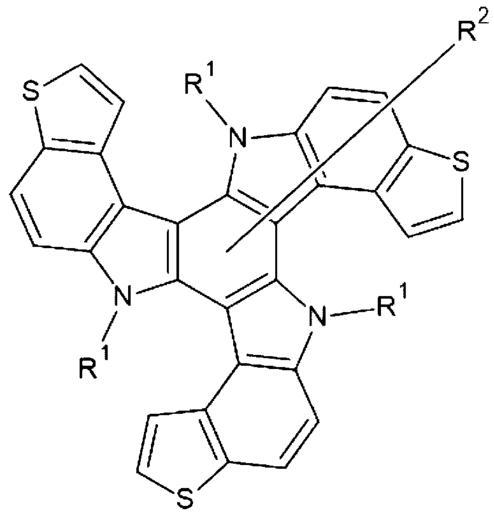

A-8

[Chemical Formulas A9A12]

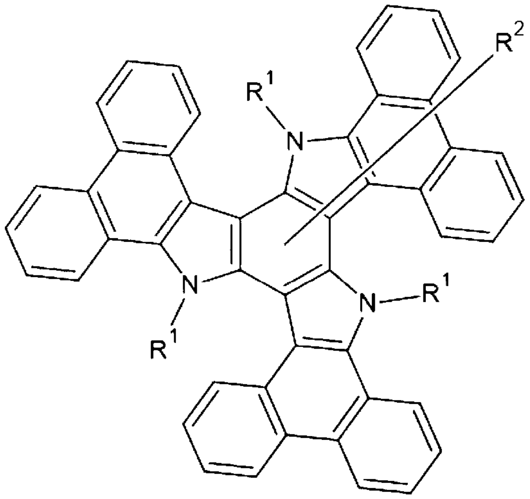

A-9

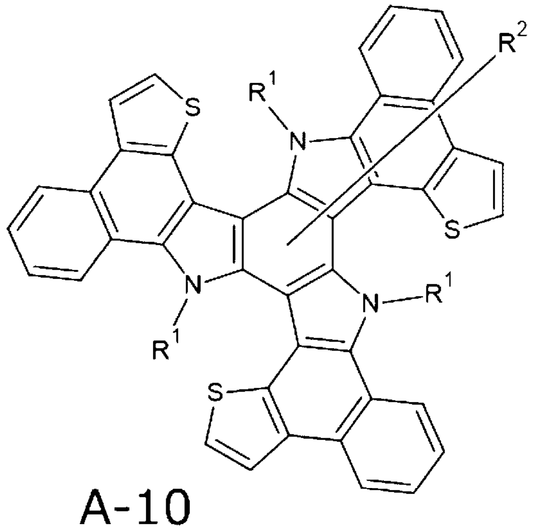

A-10

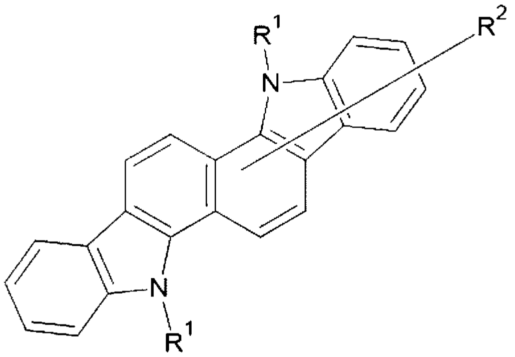

A-11

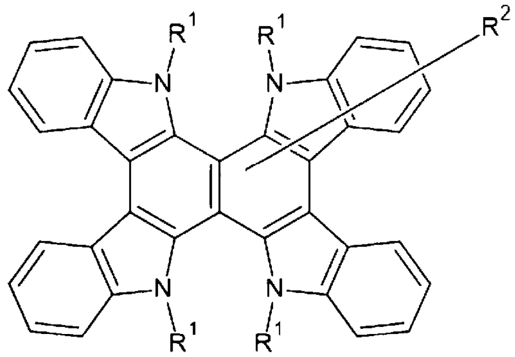

A-12

[Chemical Formulas A13A16]

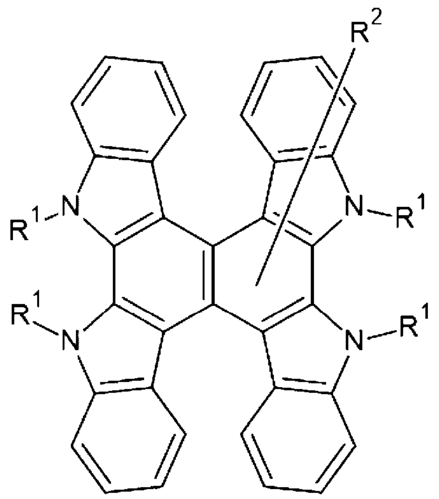

A-13

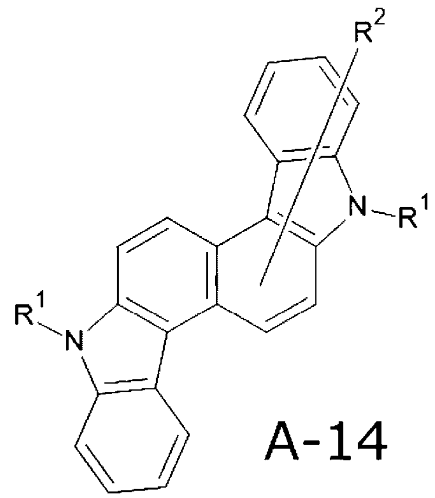

A-14

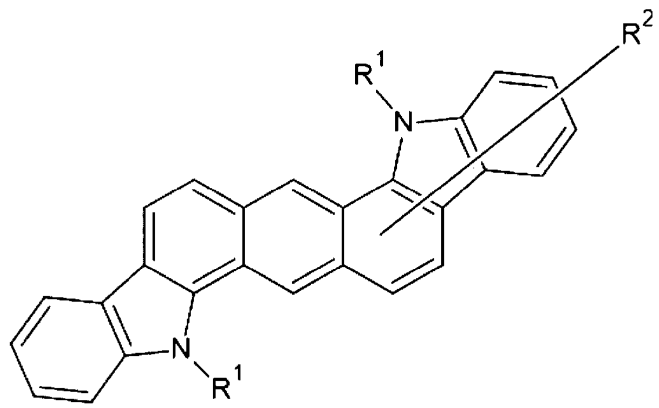

A-15

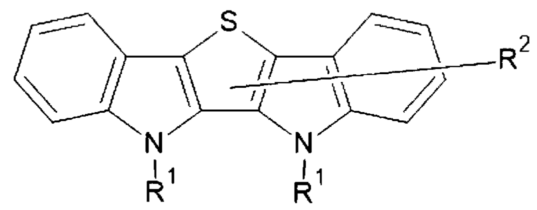

A-16

[Chemical Formulas A17A20]

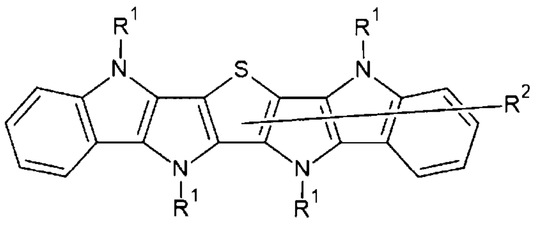

A-17

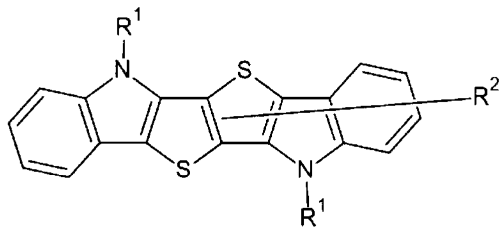

A-18

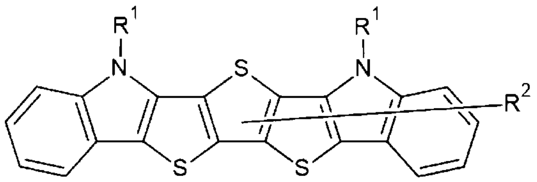

A-19

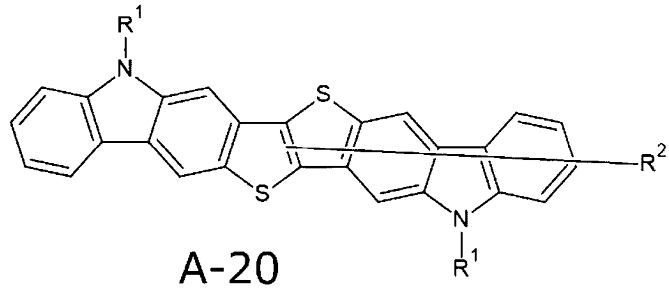

A-20

[Chemical Formulas A21A23]

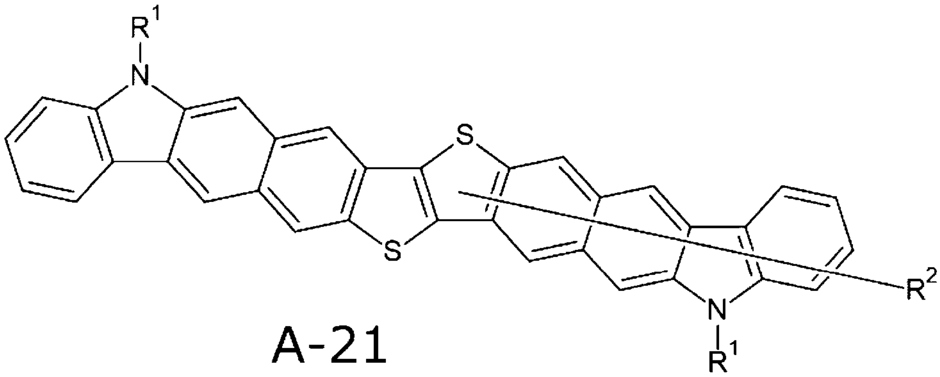

A-21

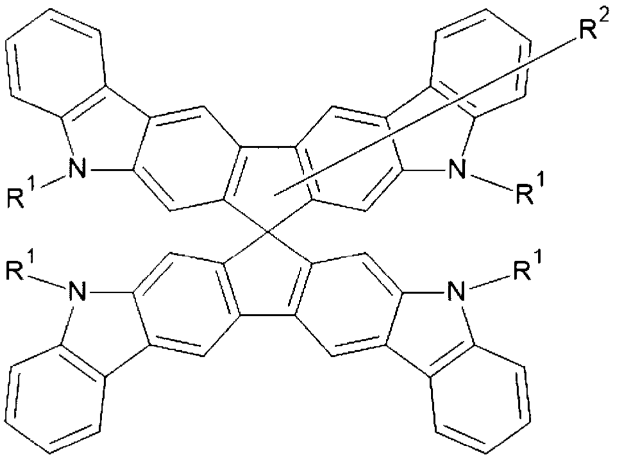

A-22

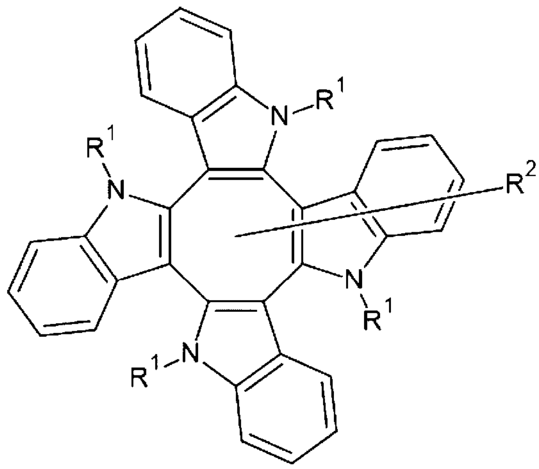

A-23

In the chemical formulas A-1 to A-23, each of the $R^1$ is a hydrogen atom, $X^1$ in the chemical formula (I), or a substituent further substituted with $X^1$ in the chemical formula (I), and may be the same as or different from each other, at least one of the $R^1$ is $X^1$ in the chemical formula (I) or a substituent further substituted with $X^1$ in the chemical formula (I), and the $R^2$ is a substituent, and may exist as one, multiple, or may not exist, and in the case of being multiple, each $R^2$ may be the same as or different from each other.

(Supplementary Note 14)

The photoelectric conversion element according to any one of Supplementary Notes 1 to 13, wherein the compound represented by the chemical formula (I) is a compound represented by the following chemical formula 4PATAT, 1-legged-3PATAT, 1-legged-3PATAT-H, 2-legged-3PATAT, 4PATTI-C3, 4PATTI-C4, or 3PATAT.

[Chemical Formula 4PATAT]

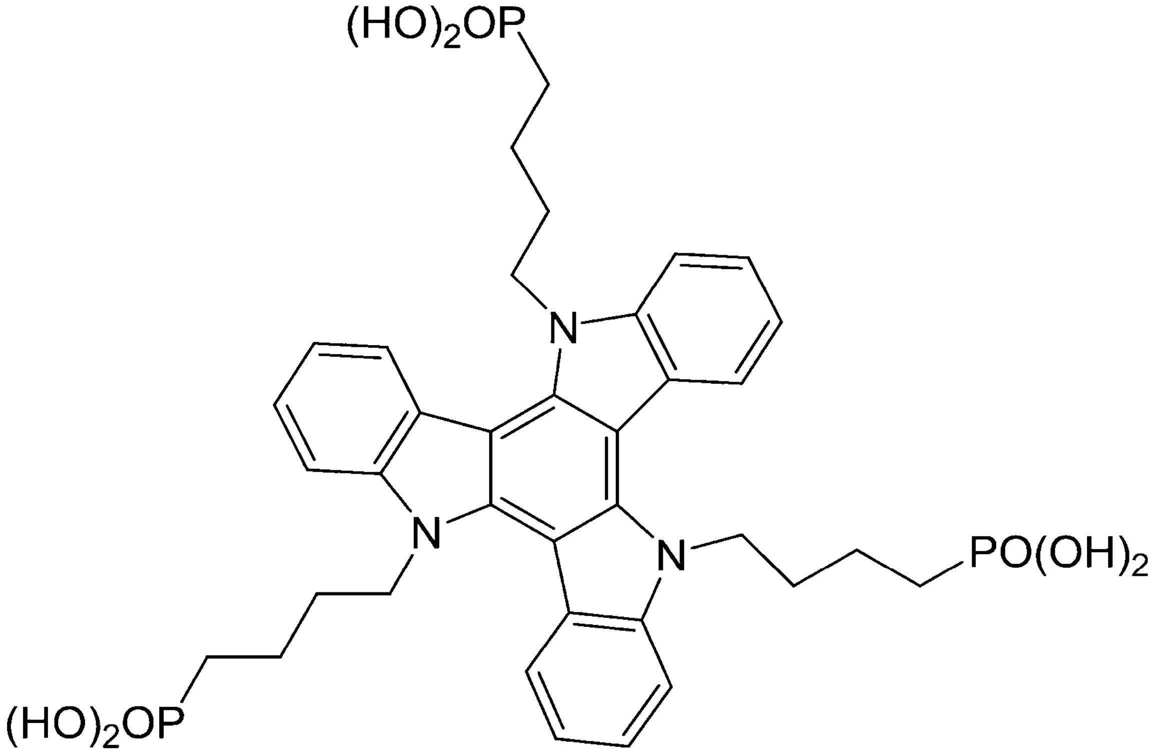

4PATAT

[Chemical Formula 3PATAT1]

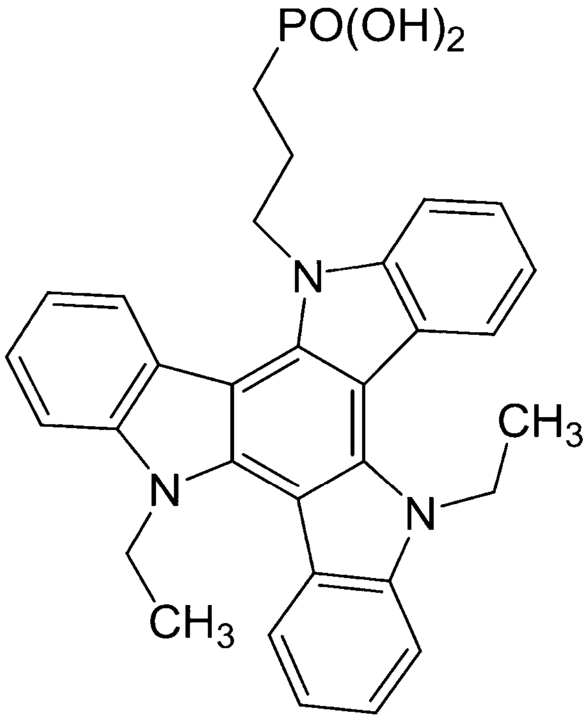

１－ｌｅｇｇｅｄ－３ＰＡＴＡＴ

[Chemical Formula 3PATATH]

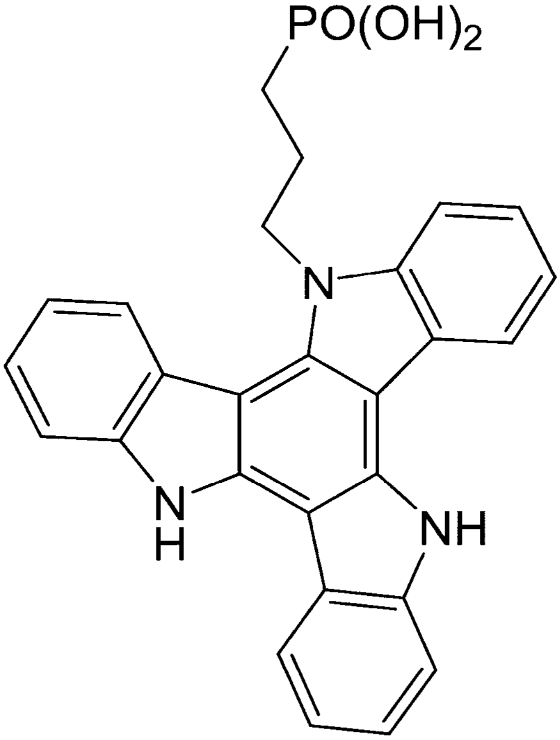

1－legged－3PATAT－H

[Chemical Formula 3PATAT2]

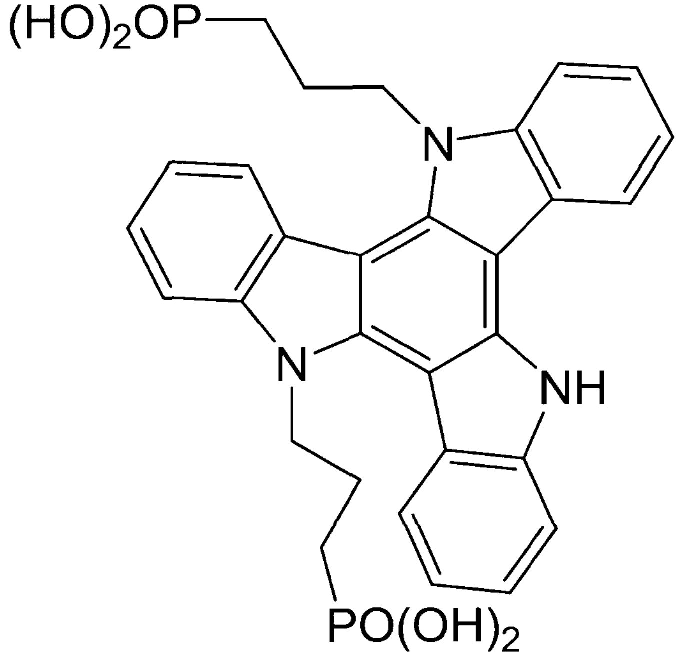

2－legged－3PATAT

[Chemical Formula 4PATTI-C3]

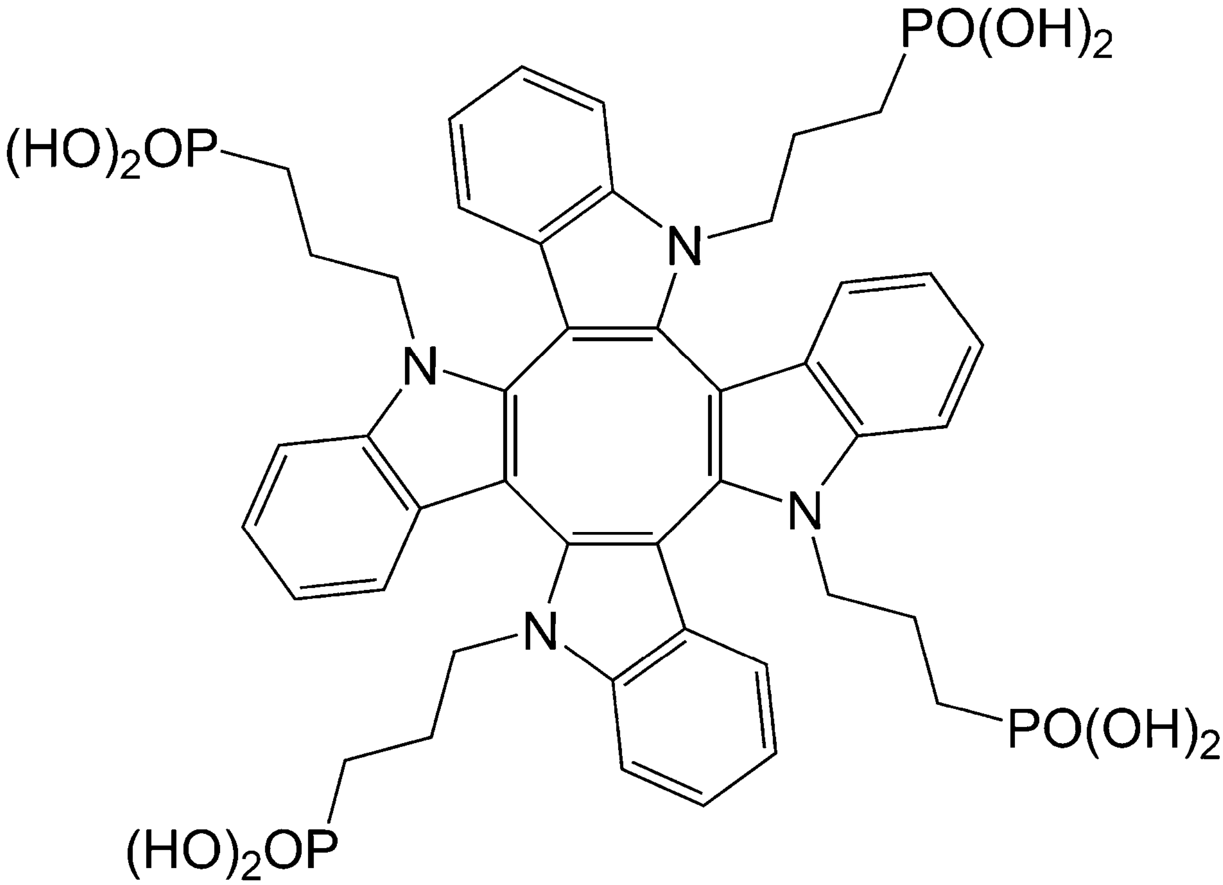

4PATTI－C3

[Chemical Formula 4PATTI-C4]

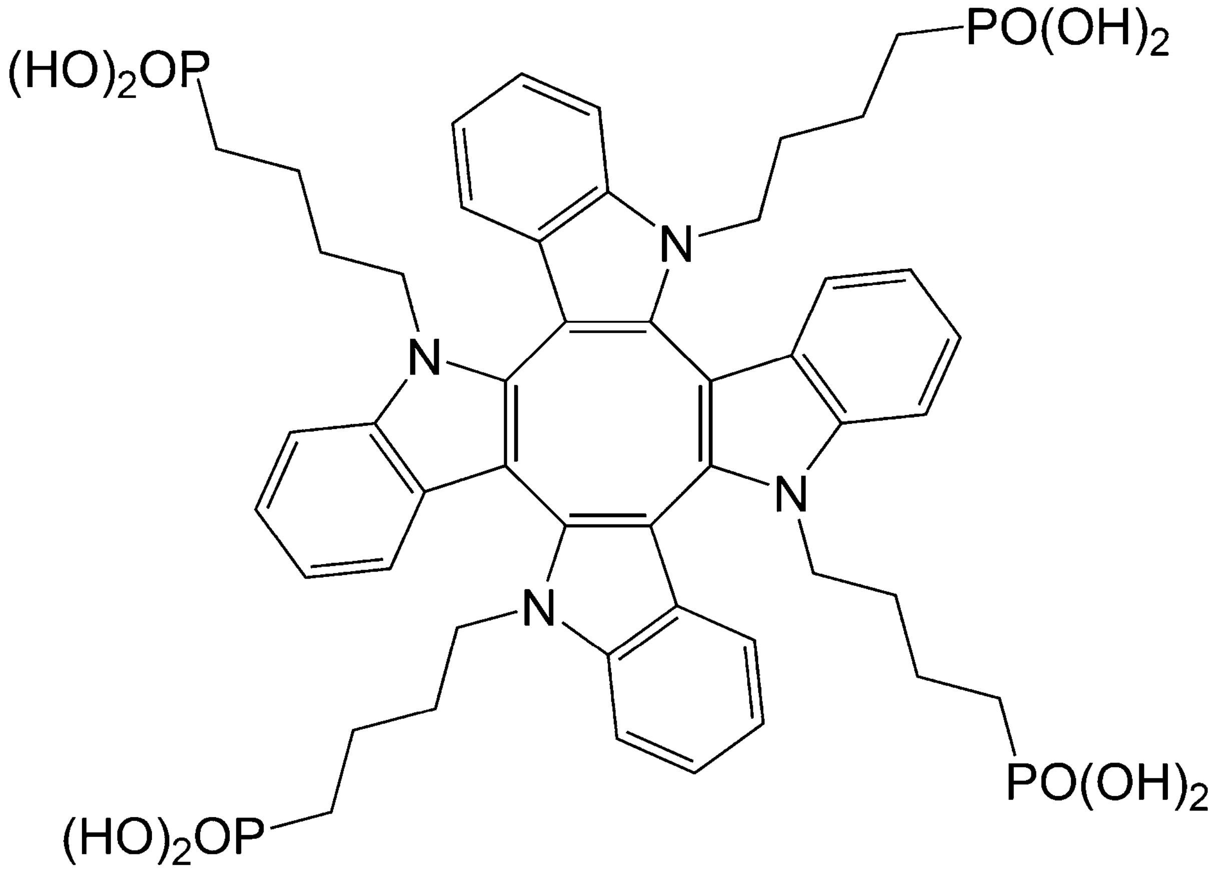

4PATTI-C4

[Chemical Formula 3PATAT]

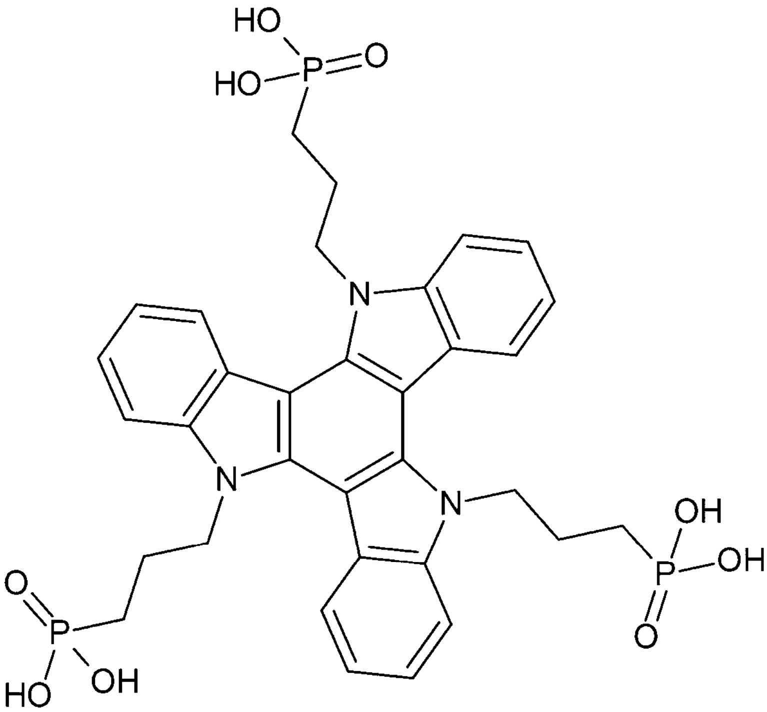

3PATAT

(Supplementary Note 15)

The photoelectric conversion element according to any one of Supplementary Notes 1 to 14, wherein in the perovskite compound contained in the photoelectric conversion layer, the salt of the formamidine contained in the raw material is at least one type selected from the group consisting of formamidine formate, formamidine acetate, formamidine thiocyanate, and formamidine chloride.

(Supplementary Note 16)

The photoelectric conversion element according to any one of Supplementary Notes 1 to 15, wherein the perovskite compound contained in the photoelectric conversion layer is formed from a solution including at least one of the formamidine and the salt thereof.

(Supplementary Note 17)

The photoelectric conversion element according to any one of Supplementary Notes 1 to 16, wherein the hole transport layer includes a compound represented by the following chemical formula (II), in addition to being represented by the chemical formula (I).

$$A^1\text{-}L^2\text{-}X^2 \qquad \text{(II)}$$

In the chemical formula (II),

$A^1$ is an atomic group including at least one substituent selected from the group consisting of an alkoxy group, a hydroxy group, a carboxy group, a dihydroxyphosphoryl group, a dialkylphosphoryl group, a hydroxysulfonyl group, a substituted or unsubstituted amino group, a substituted or unsubstituted aminocarbonyl group, an alkylcarbonyloxy group, an alkoxycarbonyl group, an aminocarbonyl group, an aminocarbonylamino group, an alkylcarbonylamino group, an alkylsulfonylamino group, an aminosulfonyl group, and a nitrogen-containing heterocyclic group,
each $L^2$ is an atomic group that bonds $A^1$ and $X^2$, or is a covalent bond, and
$X^2$ is each a group capable of exchanging charges with the first electrode.

(Supplementary Note 18)

The photoelectric conversion element according to Supplementary Note 17, wherein in the $A^1$ in the chemical formula (II), the substituted or unsubstituted amino group is at least one substituent selected from the group consisting of an amino group, a monoalkylamino group, a dialkylamino group, a monoarylamino group, a diarylamino group, and an aminocarbonylamino group.

(Supplementary Note 19)

The photoelectric conversion element according to Supplementary Note 17 or 18, wherein in the $A^1$ in the chemical formula (II), the substituted or unsubstituted aminocarbonyl group is at least one of a monoalkylaminocarbonyl group and a dialkylaminocarbonyl group.

(Supplementary Note 20)

The photoelectric conversion element according to any one of Supplementary Notes 17 to 19, wherein $L^2$ in the chemical formula (II) is a divalent linking group that bonds $A^1$ and $X^2$, or is a single bond.

(Supplementary Note 21)

The photoelectric conversion element according to any one of Supplementary Notes 17 to 20, wherein $X^2$ in the chemical formula (II) is a group capable of forming a chemical bond or a hydrogen bond with the first electrode.

(Supplementary Note 22)

The photoelectric conversion element according to any one of Supplementary Notes 17 to 21, wherein a molar ratio of the compound represented by the chemical formula (I) and the compound represented by the chemical formula (II) is in a range of 1:100 to 1:1.

(Supplementary Note 23)

The photoelectric conversion element according to any one of Supplementary Notes 17 to 22, wherein $X^2$ in the chemical formula (II) is at least one type selected from the group consisting of a dihydroxyphosphoryl group, a carboxyl group, a sulfo group, a boronic acid group, a trihalogenated silyl group, a trialkoxysilyl group, and a trihydroxysilyl group.

(Supplementary Note 24)

The photoelectric conversion element according to any one of Supplementary Notes 1 to 23, wherein the perovskite compound contained in the photoelectric conversion layer is an organic-inorganic perovskite compound.

(Supplementary Note 25)

The photoelectric conversion element according to any one of Supplementary Notes 1 to 24, wherein the perovskite compound contained in the photoelectric conversion layer includes at least one of tin and lead.

(Supplementary Note 26)

The photoelectric conversion element according to any one of Supplementary Notes 1 to 25, wherein the perovskite compound contained in the photoelectric conversion layer is a perovskite compound formed from a raw material including a salt of formamidine, and

an anion in the salt of formamidine contained in the raw material is a carboxylic acid anion.

(Supplementary Note 27)

The photoelectric conversion element according to claim 26, wherein the carboxylic acid anion is a monoanion.

(Supplementary Note 28)

The photoelectric conversion element according to any one of Supplementary Notes 1 to 27, which is a solar cell.

Industrial Applicability

As described above, according to the disclosure, it is possible to provide a photoelectric conversion element that can form a high-quality perovskite layer without using a poor solvent method, and that has excellent characteristics. The photoelectric conversion element of the disclosure is useful as, for example, a solar cell. The applications and usage methods of the photoelectric conversion element of the disclosure are not particularly limited, and the photoelectric conversion element can be applied to a wide range of fields with similar applications and usage methods to general photoelectric conversion elements (for example, general solar cells).
This application claims priority based on Japanese Patent Application No. 2023-034065 filed on March 6, 2023, the entire disclosure of which is incorporated herein.

Description of Reference Numerals

11 substrate
12 first electrode
13 hole transport layer
14 photoelectric conversion layer
15 electron transport layer
16 second electrode

**Claims**

1. A photoelectric conversion element, comprising a first electrode, an electron transport layer, a photoelectric conversion layer, a hole transport layer, and a second electrode laminated in this order, wherein

the hole transport layer comprises a compound represented by a following chemical formula (I),
the photoelectric conversion layer comprises a perovskite compound, and the perovskite compound is a perovskite compound formed from a raw material comprising at least one of formamidine and a salt thereof,

[Chemical Formula I]

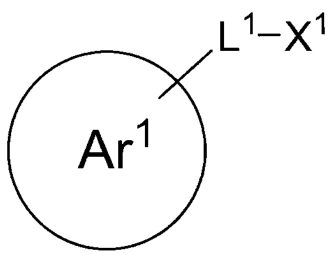

(I)

in the chemical formula (I),
$Ar^1$ is a structure comprising an aromatic ring, and optionally comprises a heteroatom among atoms constituting the aromatic ring,
$Ar^1$ optionally has a substituent other than $-L^1-X^1$,
$-L^1-X^1$ is single or multiple, and in a case of being multiple, each $L^1$ is the same as or different from each other and each $X^1$ is the same as or different from each other,
each $L^1$ is an atomic group that bonds $Ar^1$ and $X^1$, or is a covalent bond, and

each $X^1$ is a group capable of exchanging charges with the first electrode.

**2.** The photoelectric conversion element according to claim 1, wherein $Ar^1$ in the chemical formula (I) comprises a nitrogen atom among the atoms constituting the aromatic ring.

**3.** The photoelectric conversion element according to claim 1 or 2, wherein $L^1$ in the chemical formula (I) is a divalent linking group that bonds $Ar^1$ and $X^1$, or is a single bond.

**4.** The photoelectric conversion element according to any one of claims 1 to 3, wherein $X^1$ in the chemical formula (I) is a group capable of forming a chemical bond or a hydrogen bond with the first electrode.

**5.** The photoelectric conversion element according to any one of claims 1 to 4, wherein $X^1$ in the chemical formula (I) is each independently a dihydroxyphosphoryl group, a carboxyl group, a sulfo group, a boronic acid group, a trihalogenated silyl group, a trialkoxysilyl group, or a trihydroxysilyl group.

**6.** The photoelectric conversion element according to any one of claims 1 to 5, wherein in the perovskite compound contained in the photoelectric conversion layer, the salt of the formamidine contained in the raw material is at least one type selected from a group consisting of formamidine formate, formamidine acetate, formamidine thiocyanate, and formamidine chloride.

**7.** The photoelectric conversion element according to any one of claims 1 to 6, wherein the perovskite compound contained in the photoelectric conversion layer is formed from a solution comprising at least one of the formamidine and the salt thereof.

**8.** The photoelectric conversion element according to any one of claims 1 to 7, wherein the hole transport layer comprises a compound represented by a following chemical formula (II), in addition to being represented by the chemical formula (I),

$$A^1\text{-}L^2\text{-}X^2 \qquad \text{(II)}$$

in the chemical formula (II),
$A^1$ is an atomic group comprising at least one substituent selected from a group consisting of an alkoxy group, a hydroxy group, a carboxy group, a dihydroxyphosphoryl group, a dialkylphosphoryl group, a hydroxysulfonyl group, a substituted or unsubstituted amino group, a substituted or unsubstituted aminocarbonyl group, an alkylcarbonyloxy group, an alkoxycarbonyl group, an aminocarbonyl group, an aminocarbonylamino group, an alkylcarbonylamino group, an alkylsulfonylamino group, an aminosulfonyl group, and a nitrogen-containing heterocyclic group,
each $L^2$ is an atomic group that bonds $A^1$ and $X^2$, or is a covalent bond, and
$X^2$ is each a group capable of exchanging charges with the first electrode.

**9.** The photoelectric conversion element according to claim 8, wherein in the $A^1$ in the chemical formula (II), the substituted or unsubstituted amino group is at least one substituent selected from a group consisting of an amino group, a monoalkylamino group, a dialkylamino group, a monoarylamino group, a diarylamino group, and an aminocarbonylamino group.

**10.** The photoelectric conversion element according to claim 8 or 9, wherein in the $A^1$ in the chemical formula (II), the substituted or unsubstituted aminocarbonyl group is at least one of a monoalkylaminocarbonyl group and a dialkylaminocarbonyl group.

**11.** The photoelectric conversion element according to any one of claims 8 to 10, wherein $L^2$ in the chemical formula (II) is a divalent linking group that bonds $A^1$ and $X^2$, or is a single bond.

**12.** The photoelectric conversion element according to any one of claims 8 to 11, wherein $X^2$ in the chemical formula (II) is a group capable of forming a chemical bond or a hydrogen bond with the first electrode.

**13.** The photoelectric conversion element according to any one of claims 8 to 12, wherein a molar ratio of the compound

represented by the chemical formula (I) and the compound represented by the chemical formula (II) is in a range of 1:100 to 1:1.

**14.** The photoelectric conversion element according to any one of claims 8 to 13, wherein $X^2$ in the chemical formula (II) is at least one type selected from a group consisting of a dihydroxyphosphoryl group, a carboxyl group, a sulfo group, a boronic acid group, a trihalogenated silyl group, a trialkoxysilyl group, and a trihydroxysilyl group.

**15.** The photoelectric conversion element according to any one of claims 1 to 14, wherein the perovskite compound contained in the photoelectric conversion layer is an organic-inorganic perovskite compound.

**16.** The photoelectric conversion element according to any one of claims 1 to 15, wherein the perovskite compound contained in the photoelectric conversion layer comprises at least one of tin and lead.

**17.** The photoelectric conversion element according to any one of claims 1 to 16, wherein the perovskite compound contained in the photoelectric conversion layer is a perovskite compound formed from a raw material comprising a salt of formamidine, andan anion in the salt of formamidine contained in the raw material is a carboxylic acid anion.

**18.** The photoelectric conversion element according to claim 17, wherein the carboxylic acid anion is a monoanion.

**19.** The photoelectric conversion element according to any one of claims 1 to 18, being a solar cell.

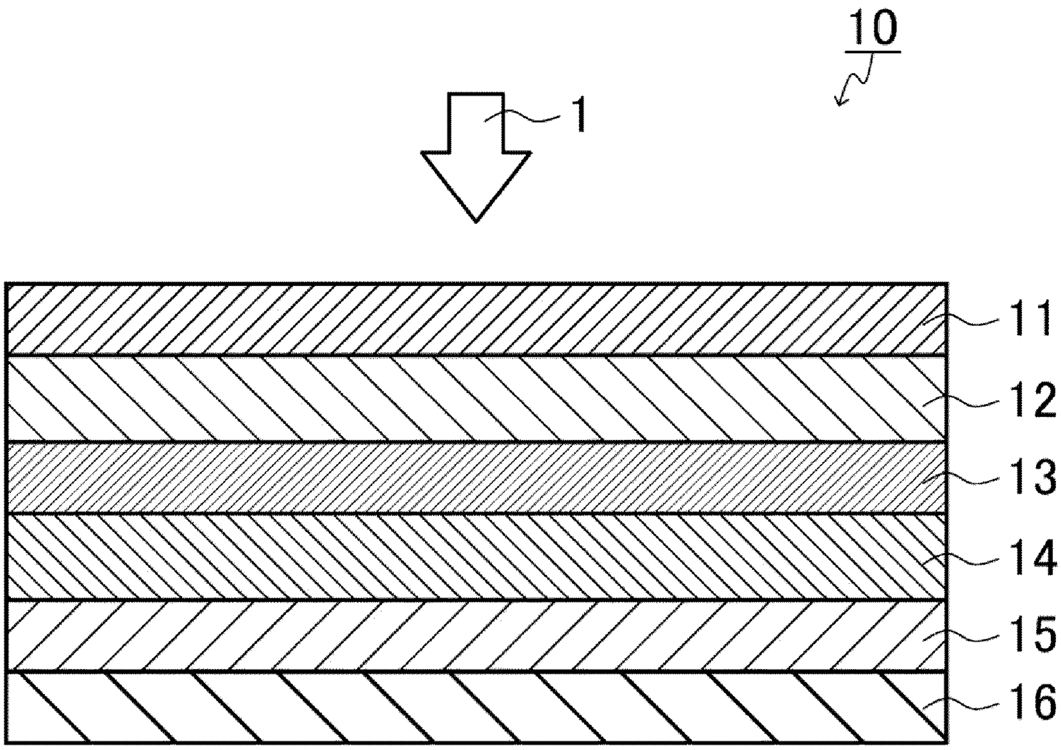


FIG. 1

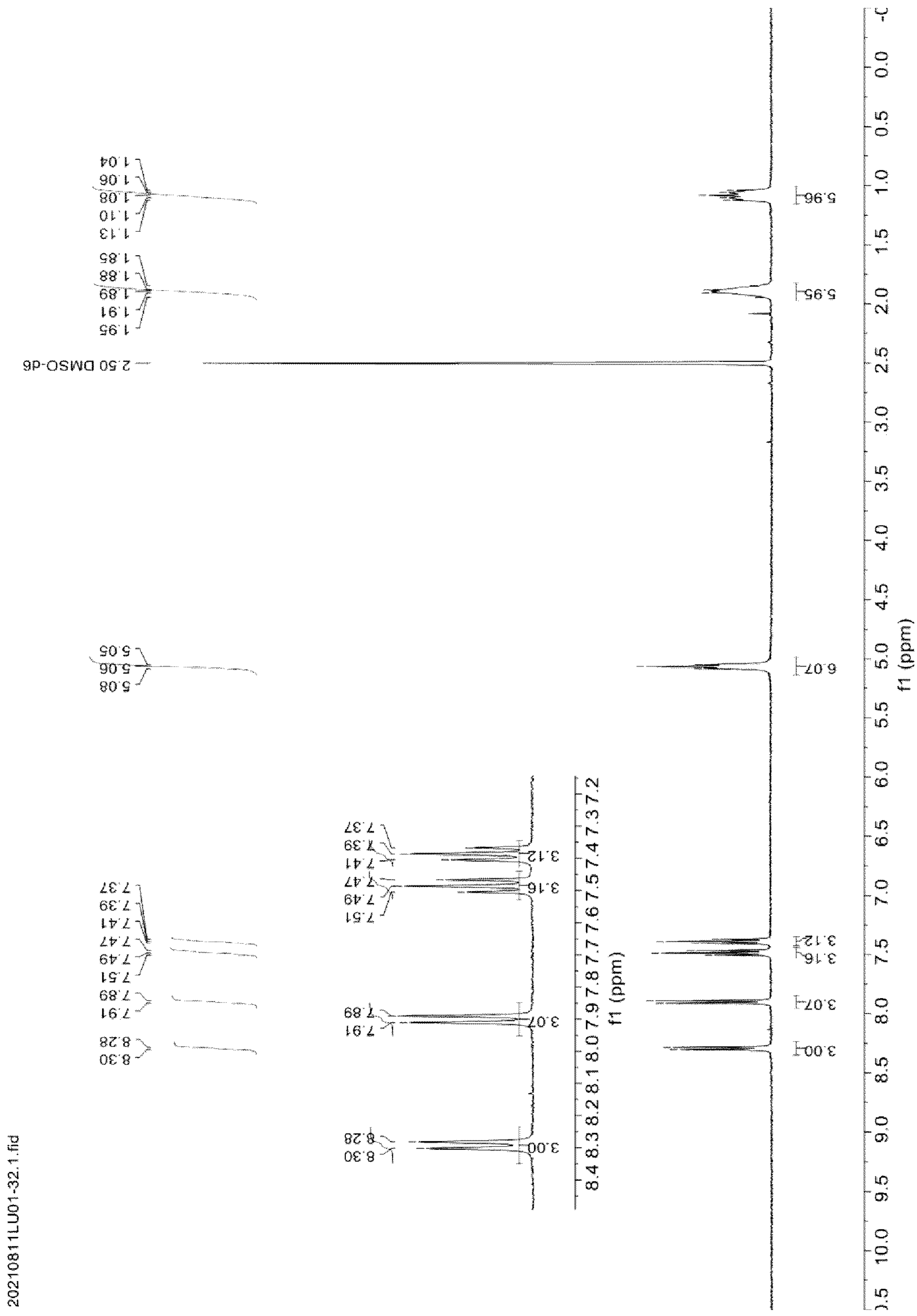


$^1H$ NMR spectrum of 3PATAT measured in DMSO-$d_6$.

FIG. 2

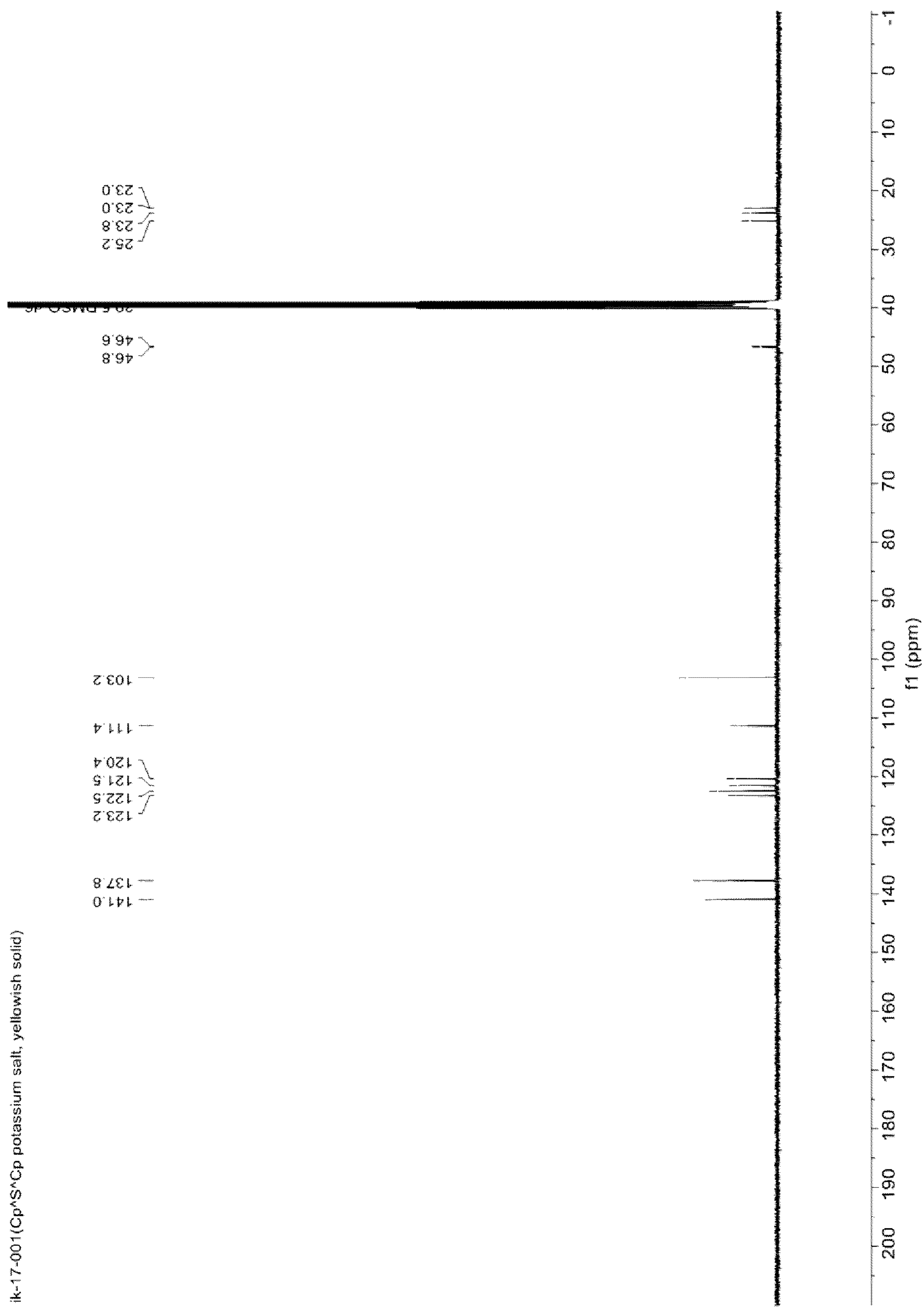


$^{13}C$ NMR spectrum of 3PATAT measured in DMSO-$d_6$.

FIG. 3

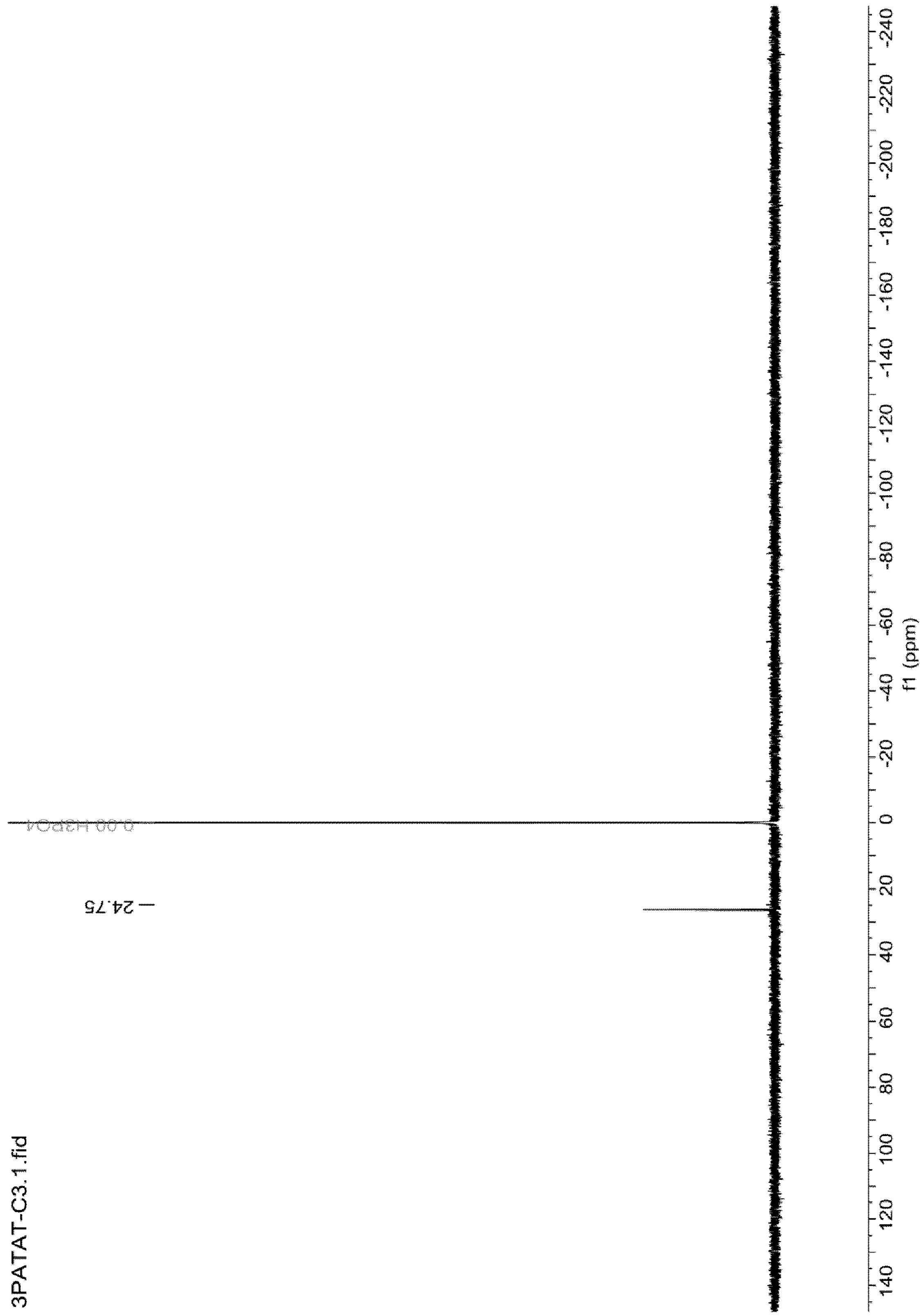


$^{31}P$ NMR spectrum of 3PATAT measured in DMSO-$d_6$.

FIG. 4

**INTERNATIONAL SEARCH REPORT**

International application No.
**PCT/JP2024/008379**

**A. CLASSIFICATION OF SUBJECT MATTER**

***H10K 30/50***(2023.01)i; ***C07F 9/6561***(2006.01)i; ***H10K 30/40***(2023.01)i; ***H10K 30/86***(2023.01)i; ***H10K 85/50***(2023.01)i
FI: H10K30/50; C07F9/6561 Z; H10K30/40; H10K30/86; H10K85/50

According to International Patent Classification (IPC) or to both national classification and IPC

**B. FIELDS SEARCHED**

Minimum documentation searched (classification system followed by classification symbols)

H10K30/00-30/89; H10K85/00-85/60

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN); JSTPlus/JSTChina/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | FARAG, Ahmed et al., Evaporated Self-Assembled Monolayer Hole Transport Layers: Lossless Interfaces in p-i-n Perovskite Solar Cells, Advanced Energy Materials, 04 January 2023, vol. 13, Article number: 2203982, pp. 1-13<br>in particular, pp. 2-9, fig. 1-5 | 1-5, 7, 15-16, 19 |
| Y | | 6-19 |
| Y | JP 2019-46935 A (MITSUBISHI CHEMICAL CORPORATION) 22 March 2019 (2019-03-22)<br>paragraphs [0011]-[0107], fig. 1 | 1-19 |
| Y | TRUONG, Minh Anh et al., Efficient Inverted Perovskite Solar Cells Enabled by Multipodal Hole-Collecting Monolayers based on Triazatruxene Skeleton, Technical Digest of PVSEC-33, 2022.11, Sub area 4-1: Mo0-41a-02<br>in particular, lines 6-28, fig. 1, 2 | 1-19 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/008379**

**C. DOCUMENTS CONSIDERED TO BE RELEVANT**

| Category* | Citation of document, with indication, where appropriate, of the relevant passages | Relevant to claim No. |
|---|---|---|
| Y | JP 2022-71063 A (HUNT PEROVSKITE TECHNOLOGIES, LLC) 13 May 2022 (2022-05-13)<br>paragraphs [0083]-[0090] | 1-19 |
| Y | JP 2018-536995 A (OXFORD UNIVERSITY INNOVATION LTD.) 13 December 2018 (2018-12-13)<br>paragraphs [0104]-[0107] | 1-19 |
| Y | ZHAO, Zhiqiang et al., Modified HTL-induced efficiency enhancement for inverted perovskite solar cells, Organic Electronics, 2020, vol. 78, Article number: 105557, pp. 1-7<br>in particular, abstract, 2. Experimental, scheme 1 | 8-19 |
| P, X<br><br>P, A | WO 2023/038050 A1 (ENECOAT TECHNOLOGIES CO., LTD.) 16 March 2023 (2023-03-16)<br>paragraphs [0168]-[0237], fig. 1 | 1-5, 7, 15-16, 19<br><br>6, 8-14, 17-18 |
| A | CN 110698654 A (CHANGCHUN INSTITUTE OF APPLIED CHEMISTRY, CHINESE ACADEMY OF SCIENCES) 17 January 2020 (2020-01-17) | 1-19 |
| A | CAPRIOGLIO, Pietro et al., Open-circuit and short-circuit loss management in wide-gap perovskite p-i-n solar cells, Nature Communications, February 2023, vol. 14, Article number: 932, pp. 1-13 | 1-19 |

Form PCT/ISA/210 (second sheet) (July 2022)

**INTERNATIONAL SEARCH REPORT**
**Information on patent family members**

International application No.
**PCT/JP2024/008379**

| Patent document cited in search report | Publication date (day/month/year) | Patent family member(s) | Publication date (day/month/year) |
|---|---|---|---|
| JP 2019-46935 A | 22 March 2019 | JP 2022-100405 A | |
| JP 2022-71063 A | 13 May 2022 | EP 3741767 A1<br>paragraphs [0082]-[0090]<br>US 2021/0280801 A1<br>KR 10-2021-0103591 A<br>CN 115172605 A | |
| JP 2018-536995 A | 13 December 2018 | US 2018/0351123 A1<br>paragraphs [0217]-[0219]<br>WO 2017/089819 A1<br>CN 108369991 A<br>KR 10-2018-0098272 A | |
| WO 2023/038050 A1 | 16 March 2023 | (Family: none) | |
| CN 110698654 A | 17 January 2020 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2023034065 A

### Non-patent literature cited in the description

- *Journal of the American Chemical Society*, 2009, vol. 131, 6050-6051
- *Science*, 2012, vol. 388, 643-647